# EUROPEAN PATENT APPLICATION

(11) **EP 4 521 873 A1**
(43) Date of publication of application: **12.03.2025**
(21) Application number: 24728006.8
(22) Date of filing: 17.05.2024
(51) Int. Cl.: H05K 9/00, H05K 7/20, H04M 1/02

(54) **ELECTRONIC DEVICE INCLUDING SHIELDING STRUCTURE FOR ELECTRONIC COMPONENT**

(30) Priority: 19.07.2023 KR 20230093759; 25.07.2023 KR 20230097068
(71) Applicant: Samsung Electronics Co., Ltd., Suwon-si, Gyeonggi-do 16677 (KR)
(72) Inventor: LEE, Haejin, Suwon-si Gyeonggi-do 16677 (KR); AHN, Joseph, Suwon-si Gyeonggi-do 16677 (KR)
(74) Representative: HGF
(86) International application number: PCT/KR2024/006718
(87) International publication number: WO 2025/018546

(57) **Abstract**

According to an embodiment, an electronic device includes an electronic component and a shield can on including an opening facing the electronic component. The electronic device includes a shielding structure on the shield can covering the opening and a heat conduction member between the electronic component and the shielding structure attached on the electronic component and contacting the shielding structure through the opening. The electronic device includes a metal plate on the shielding structure and at least one heat dissipation member attached to the metal plate. The shielding structure includes a first shielding member attached on the shield can and a second shielding member attached on the first shielding member. A density of the first shielding member is smaller than a density of the second shielding member.

## Description

### [Technical Field]

Various embodiments to be described later relate to an electronic device including a shielding structure for an electronic component.

### [Background Art]

A small electronic device such as a smart phone or a tablet personal computer (PC), and the like may include electronic components in the electronic device to implement various function of the electronic device. In order to reduce performance degradation of the electronic components due to radio waves generated by operation of the electronic components, the electronic device may include a structure that shields the electronic components.

The above-described information may be provided as a related art for the purpose of helping understanding of the present disclosure. No argument or decision is made as to whether any of the above description may be applied as a prior art related to the present disclosure.

### [Disclosure]

### [Technical Solution]

According to an embodiment, an electronic device may include a printed circuit board (PCB), an electronic component coupled on the PCB, and a shield can on the PCB surrounding the electronic component and including an opening facing the electronic component. The electronic device may include a shielding structure on the shield can covering the opening and a heat conduction member between the electronic component and the shielding structure attached on the electronic component and contacting the shielding structure through the opening. The electronic device may include a metal plate on the shielding structure and at least one heat dissipation member attached to the metal plate and configured to receive at least a portion of heat emitted from the electronic component through the heat conduction member. The shielding structure may include a first shielding member attached on the shield can, a first adhesive member interposed between the first shielding member and the shield can to attach the first shielding member to the shield can, a second shielding member attached on the first shielding member and a second adhesive member interposed between the first shielding member and the second shielding member to attach the second shielding member to the first shielding member. A density of the first shielding member may be smaller than a density of the second shielding member.

According to an embodiment, an electronic device may include a printed circuit board (PCB), an electronic component coupled on the PCB, and a shield can on the PCB surrounding the electronic component and including an opening facing the electronic component. The electronic device may include a shielding structure on the shield can covering the opening and a heat conduction member between the electronic component and the shielding structure attached on the electronic component and contacting the shielding structure through the opening. The electronic device may include a metal plate on the shielding structure and at least one heat dissipation member attached to the metal plate and configured to receive at least a portion of heat emitted from the electronic component through the heat conduction member. The shielding structure may include a first shielding member attached on the shield can, a first adhesive member interposed between the first shielding member and the shield can to attach the first shielding member to the shield can, a second shielding member attached on the first shielding member and a second adhesive member interposed between the first shielding member and the second shielding member to attach the second shielding member to the first shielding member, a protection member disposed on the second shielding member, and a groove indented toward the metal plate from the opening to accommodate the heat conduction member penetrating the opening. A density of the first shielding member may be smaller than a density of the second shielding member.

### [Description of the Drawings]

FIG. 1 is a block diagram of an electronic device in a network environment according to an embodiment.
FIG. 2A is a diagram representing the electronic device according to an embodiment.
FIG. 2B is an exploded perspective view of the electronic device according to an embodiment.
FIG. 3A is a partial cross-sectional view of an exemplary electronic device.
FIG. 3B illustrates a portion of the exemplary electronic device.
FIG. 3C illustrates a shielding structure of an electronic component of the exemplary electronic device.
FIGS. 4A, 4B, 4C, 4D, and 4E are partial cross-sectional view of the exemplary electronic device.
FIGS. 5A and 5B are partial cross-sectional views of the exemplary electronic device.
FIG. 6 is a partial cross-sectional view of the exemplary electronic device.
FIG. 7 illustrates a lamination process of the shielding structure of the exemplary electronic device.
FIG. 8A illustrates an example of an unfolding state of the exemplary electronic device according to an embodiment.
FIG. 8B illustrates the example of a folding state of the exemplary electronic device according to an embodiment.
FIG. 8C is an exploded view of the exemplary electronic device according to an embodiment.

### [Mode for Invention]

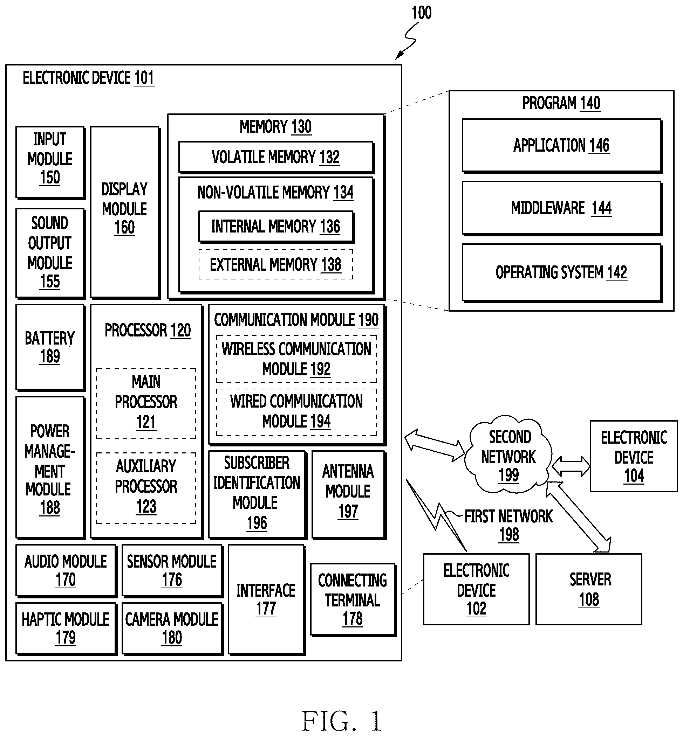

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

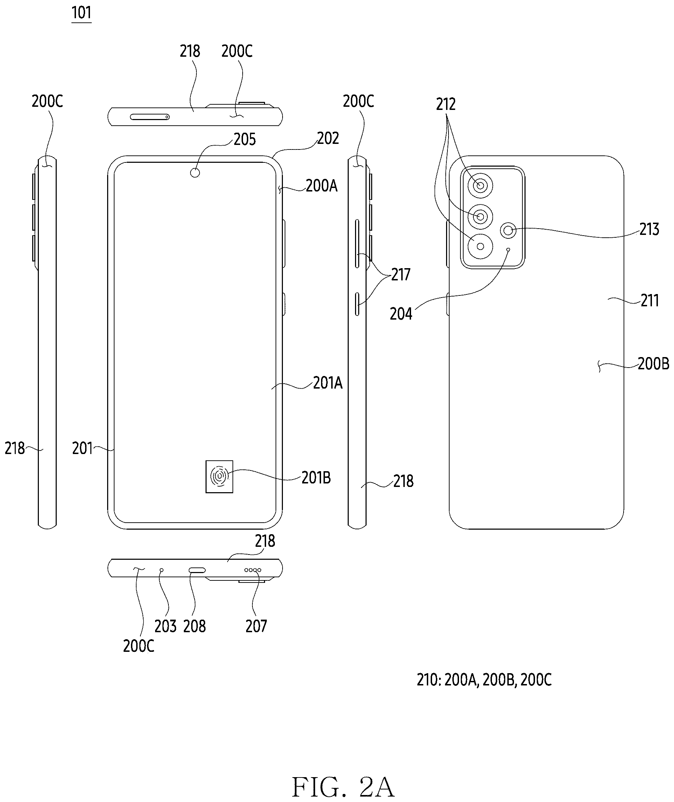

FIG. 2A is a diagram illustrating an electronic device according to an embodiment.

Referring to FIG. 2A, the electronic device 101 according to an embodiment may include a housing 210 forming an exterior of the electronic device 101. For example, the housing 210 may include a front surface 200A, a rear surface 200B, and a side surface 200C surrounding a space between the front surface 200A and the rear surface 200B. According to an embodiment, the housing 210 may refer to a structure forming at least a portion of the front surface 200A, the rear surface 200B, and/or the side surface 200C.

The electronic device 101 according to an embodiment may include a substantially transparent front plate 202. According to an embodiment, the front plate 202 may form at least a portion of the front surface 200A. According to an embodiment, the front plate 202 may include a glass plate or a polymer plate including various coating layers, but is not limited to thereto.

The electronic device 101 according to an embodiment may include a substantially opaque rear plate 211. According to an embodiment, the rear plate 211 may form at least a portion of the rear surface 200B. According to an embodiment, the rear plate 211 may be formed of coated or colored glass, ceramic, polymer, metal (e.g., aluminum, stainless steel (STS), or magnesium), or a combination of at least two of the above materials.

The electronic device 101 according to an embodiment may include a side bezel structure (or a side member) 218. According to an embodiment, the side bezel structure 218 may be coupled to the front plate 202 and/or the rear plate 211 to form at least a portion of the side surface 200C of the electronic device 101. For example, the side bezel structure 218 may form the entire side surface 200C of the electronic device 101, and for another example, the side bezel structure 218 may form the side surface 200C of the electronic device 101 together with the front plate 202 and/or the rear plate 211.

Unlike the illustrated embodiment, in case that the side surface 200C of the electronic device 101 is partially formed by the front plate 202 and/or the rear plate 211, the front plate 202 and/or the rear plate 211 may include a region that is bent toward the rear plate 211 and/or the front plate 202 at its periphery and is seamlessly extended. For example, the extended region of the front plate 202 and/or the rear plate 211 may be located at both ends of a long edge of the electronic device 101 but is not limited by the above-described example.

According to an embodiment, the side bezel structure 218 may include a metal and/or a polymer. According to an embodiment, the rear plate 211 and the side bezel structure 218 may be integrally formed, and may include the same material (e.g., a metal material such as aluminum), but are not limited thereto. For example, the rear plate 211 and the side bezel structure 218 may be formed in separate configuration and/or may include a different material.

According to an embodiment, the electronic device 101 may include at least one of a display 201 (e.g., a display module 160 of FIG. 1), an audio module 203, 204, and 207 (e.g., an audio module 170 of FIG. 1), a sensor module (e.g., the sensor module 176 of FIG. 1)(not illustrated), a camera module 205 and 212 (e.g., a camera module 180 of FIG. 1), a key input device 217 (e.g., a input module 150 of FIG. 1), a light emitting element (not illustrated), and/or a connector hole 208. According to an embodiment, the electronic device 101 may omit at least one of the components (e.g., the key input device 217 or the light emitting device (not illustrated) or may additionally include another component.

According to an embodiment, the display 201 may be visually exposed through a large portion of the front plate 202. For example, at least a portion of the display 201 may be visible through the front plate 202 forming the front surface 200A. According to an embodiment, the display 201 may be disposed at a back surface of the front plate 202.

According to an embodiment, the outer shape of the display 201 may be formed generally the same as the outer shape of the front plate 202 adjacent to the display 201. According to an embodiment, in order to expand an area in which the display 201 is visually exposed, the distance between the outer periphery of the display 201 and the outer periphery of the front plate 202 may be formed generally the same.

According to an embodiment, the display 201 (or the front surface 200A of the electronic device 101) may include a screen display region 201A. According to an embodiment, the display 201 may provide visual information to a user through the screen display region 201A. In the illustrated embodiment, when the front surface 200A is viewed frontally, the screen display region 201A is illustrated to be spaced apart from the outer periphery of the front surface 200A and located inside the front surface 200A, but is not limited thereto. In another embodiment, when the front surface 200A is viewed frontally, at least a portion of the periphery of the screen display region 201A may substantially coincide with the periphery of the front surface 200A (or the front plate 202).

According to an embodiment, the screen display region 201A may include a sensing region 201B configured to obtain a biometric information of the user. Here, the meaning of "the screen display region 201A includes the sensing region 201B" may be understood as overlapping at least a portion of the sensing region 201B with the screen display region 201A. For example, the sensing region 201B, like other region of the screen display region 201A, may mean the region in which visual information may be displayed by the display 201 and the biometric information of the user (e.g., fingerprint) additionally obtained. According to an embodiment, the sensing region 201B may be formed in the key input device 217.

According to an embodiment, the display 201 may include the region in which a first camera 205 is located. According to an embodiment, an opening is formed in the region of the display 201, and the first camera 205 (e.g., a punch hole camera) may be at least partially disposed in the opening to face the front surface 200A. In this case, the screen display region 201A may surround at least a portion of the periphery of the opening. According to an embodiment, the first camera 205 (e.g., an under display camera (UDC)) may be disposed under the display 201 to overlap with the region of the display 201. In this case, the display 201 may provide visual information to the user through the region, and additionally, the first camera 205 may obtain an image corresponded to a direction toward the front 200A through the region of the display 201.

According to an embodiment, the display 201 may be combined with or disposed adjacent to a touch sensing circuit, a pressure sensor capable of measuring the strength (pressure) of the touch, and/or a digitizer that detects a magnetic field-type stylus pen.

According to an embodiment, the audio module 203, 204, and 207 may include a microphone hole 203 and 204 and a speaker hole 207.

According to an embodiment, the microphone hole 203 and 204 may include a first microphone hole 203 formed in a partial region of the side surface 200C and a second microphone hole 204 formed in a partial region of the rear surface 200B. The microphone (not illustrated) for obtaining an external sound may be disposed inside the microphone hole 203 and 204. The microphone may include a plurality of microphone to detect a direction of sound.

According to an embodiment, a second microphone hole 204 formed in a partial region of the rear surface 200B may be disposed adj acent to the camera module 205 and 212. For example, a second microphone hole 204 may obtain sound according to operation of the camera modules 205 and 212. However, it is not limited thereto.

According to an embodiment, the speaker hole 207 may include an external speaker hole 207 and a call receiver hole (not illustrated). The external speaker hole 207 may be formed on a portion of the side surface 200C of the electronic device 101. According to an embodiment, the external speaker hole 207 may be implemented as the microphone hole 203 and one hole. Although not illustrated, the call receiver hole (not illustrated) may be formed on another portion of the side surface 200C. For example, the call receiver hole may be formed on the opposite side of the external speaker hole 207 on the side surface 200C. For example, based on illustration of FIG. 2A, the external speaker hole 207 may be formed on the side surface 200C corresponding to the lower end of the electronic device 101, and the call receiver hole may be formed on the side surface 200C corresponding to the upper end of the electronic device 101. However, it is not limited thereto, and according to an embodiment, the call receiver hole may be formed at a location other than the side surface 200C. For example, the call receiver hole may be formed by a spaced space between the front plate 202 (or the display 201) and the side bezel structure 218.

According to an embodiment, the electronic device 101 may include at least one speaker (not illustrated) configured to output sound to the outside of the housing through the external speaker hole 207 and/or the call receiver hole (not illustrated). For example, the speaker may include a piezo speaker configured to output audio by vibrating the diaphragm in the speaker using a piezoelectric element. However, it is not limited thereto.

According to an embodiment, the sensor module (not illustrated) may generate an electrical signal or data value corresponding to an internal operating state or an external environmental state of the electronic device 101. For example, the sensor module may include at least one of a proximity sensor, a heart rate monitor (HRM) sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera module 205 and 212 may include the first camera 205 disposed to face the front 200A of the electronic device 101, and a second camera 212 disposed to face the rear 200B of the electronic device 101.

According to an embodiment, a second camera 212 may include a plurality of cameras (e.g., dual camera, triple camera, or quad camera). However, a second camera 212 is not necessarily limited to including a plurality of cameras, and may include one camera.

According to an embodiment, the first camera 205 and a second camera 212 may include one or more lenses, an image sensor, and/or an image signal processor.

In an embodiment, the electronic device 101 may include a flash 213 disposed to face the rear surface 200B. According to an embodiment, for example, the flash 213 may include a light emitting diode or a xenon lamp. According to an embodiment, two or more lenses (infrared camera, wide-angle and telephoto lens) and image sensors may be disposed at one surface of the electronic device 101.

According to an embodiment, the key input device 217 may be disposed at the side surface 200C of the electronic device 101. According to an embodiment, the electronic device 101 may not include a portion or all of the key input device 217, and the key input device 217 that are not included may be implemented in another form such as a soft key on the display 201.

According to an embodiment, the connector hole 208 may be formed on the side surface 200C of the electronic device 101 so that the connector of the external device may be accommodated. A connection terminal (e.g., a connection terminal 178 of FIG. 1) electrically connected to the connector of the external device may be disposed in the connector hole 208. The electronic device 101 according to an embodiment may include an interface module (e.g., the interface 177 of FIG. 1) for processing the electrical signal transmitted and received through the connection terminal.

According to an embodiment, the electronic device 101 may include the light emitting element (not illustrated). For example, the light emitting element (not illustrated) may be disposed on the front surface 200A of the housing. The light emitting element (not illustrated) may provide state information of the electronic device 101 in an optical form. According to an embodiment, the light emitting element (not illustrated) may provide a light source interlocked with an operation of a first camera 205. For example, the light emitting element (not illustrated) may include an LED, an IR LED, and/or the xenon lamp.

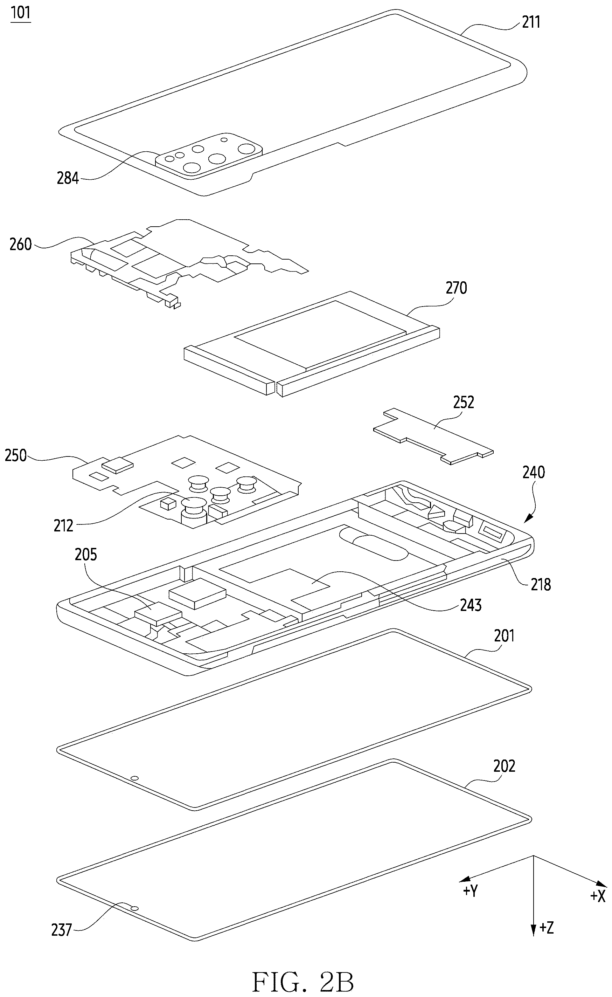

FIG. 2B is an exploded perspective view of an electronic device according to an embodiment.

Hereinafter, overlapping description of a configuration having the same reference code as the above-described configuration will be omitted.

Referring to FIG. 2B, an electronic device 101 according to an embodiment may include a display 201, a front plate 202, a rear plate 211, a frame structure 240, a first printed circuit board 250, a second printed circuit board 252, a cover plate 260, and a battery 270 (e.g., a battery 189 of FIG. 1).

According to an embodiment, the frame structure 240 may include a side bezel structure 218 forming an exterior (e.g., a side 200C of FIG. 2A) of the electronic device 101 and a support structure 243 extended inward from the side bezel structure 218. According to an embodiment, the frame structure 240 may be disposed between the display 201 and the rear plate 211. According to an embodiment, the side bezel structure 218 of the frame structure 240 may surround a space between the rear plate 211 and the front plate 202 (and/or the display 201), and the support structure 243 of the frame structure 240 may be extended from the side bezel structure 218 in the space.

According to an embodiment, the frame structure 240 may support or accommodate other components included in the electronic device 101. For example, the display 201 may be disposed at one surface of the frame structure 240 facing in one direction (e.g., +z direction), and the display 201 may be supported by the support structure 243 of the frame structure 240. For example, the first printed circuit board 250, the second printed circuit board 252, the battery 270, and a second camera 212 may be disposed at the other surface facing the direction (e.g., -z direction) opposite to the one direction of the frame structure 240. The first printed circuit board 250, the second printed circuit board 252, the battery 270, and the second camera 212 may be seated in a recess defined by the side bezel structure 218 and/or the support structure 243 of the frame structure 240.

According to an embodiment, the first printed circuit board 250, the second printed circuit board 252, and the battery 270 may be coupled to the frame structure 240, respectively. For example, the first printed circuit board 250 and the second printed circuit board 252 may be fixedly disposed at the frame structure 240 through a coupling member such as a screw. For example, the battery 270 may be fixedly disposed at the frame structure 240 through an adhesive member (e.g., a double-sided tape). However, it is not limited by the above-described example.

According to an embodiment, the cover plate 260 may be disposed between the first printed circuit board 250 and the rear plate 211. According to an embodiment, the cover plate 260 may be disposed on the first printed circuit board 250. For example, the cover plate 260 may be disposed at the surface of the first printed circuit board 250 facing the -z direction.

According to an embodiment, the cover plate 260 may at least partially overlap the first printed circuit board 250 based on the z-axis. According to an embodiment, the cover plate 260 may cover at least a portion of the first printed circuit board 250. Through this, the cover plate 260 may protect the first printed circuit board 250 from a physical impact or prevent the connector coupled to the first printed circuit board 250 from being separated.

According to an embodiment, the cover plate 260 may be fixedly disposed at the first printed circuit board 250 through the coupling member (e.g., a screw), or may be coupled to the frame structure 240 together with the first printed circuit board 250 through the coupling member.

According to an embodiment, the display 201 may be disposed between the frame structure 240 and the front plate 202. For example, the front plate 202 may be disposed on one side (e.g., +z direction) of the display 201, and the frame structure 240 may be disposed on the other side (e.g., -z direction).

According to an embodiment, the front plate 202 may be coupled to the display 201. For example, the front plate 202 and the display 201 may be adhered to each other through an optical adhesive member (e.g., optically clear adhesive (OCA) or optically clear resin (OCR) interposed between them.

According to an embodiment, the front plate 202 may be coupled to the frame structure 240. For example, the front plate 202 may include an outer portion extended outside the display 201 when viewed in the z-axis direction, and may be adhered to the frame structure 240 through an adhesive member (e.g., double-sided tape) disposed between the outer portion of the front plate 202 and the frame structure 240 (e.g., the side bezel structure 218). However, it is not limited by the above-described example.

According to an embodiment, the first printed circuit board 250 and/or the second printed circuit board 252 may be equipped with a processor (e.g., a processor 120 of FIG. 1), a memory (e.g., a memory 130 of FIG. 1), and/or an interface (e.g., an interface 177 of FIG. 1). For example, the processor may include one or more of a central processing unit, an application processor, a graphics processing unit, an image signal processor, a sensor hub processor, or a communication processor. For example, the memory may include, a volatile memory (e.g., volatile memory 132 of FIG. 1) or a nonvolatile memory (e.g., nonvolatile memory 134 of FIG. 1). For example, the interface may include a high definition multimedia interface (HDMI), a universal serial bus (USB) interface, an SD card interface, and/or an audio interface. The interface may electrically or physically connect the electronic device 101 to an external electronic device, and may include a USB connector, an SD card/multimedia card (MMC) connector, or an audio connector. According to an embodiment, the first printed circuit board 250 and the second printed circuit board 252 may be operatively or electrically connected to each other through a connection member (e.g., a flexible printed circuit board).

According to an embodiment, the battery 270 may supply power to at least one component of the electronic device 101. For example, the battery 270 may include a rechargeable secondary battery or a fuel cell. At least a portion of the battery 270 may be disposed substantially on the same plane as the first printed circuit board 250 and/or the second printed circuit board 252.

The electronic device 101 according to an embodiment may include an antenna module (not illustrated). According to an embodiment, the antenna module may be disposed between the rear plate 211 and the battery 270. For example, the antenna module may include a near field communication (NFC) antenna, a wireless charging antenna, and/or a magnetic secure transmission (MST) antenna. For example, the antenna module may perform short-range communication with the external device or wirelessly transmit and receive power with the external device.

According to an embodiment, the first camera 205 (e.g., a front camera) may be disposed at least a portion (e.g., the support structure 243) of the frame structure 240 so that the lens may receive external light through a partial region (e.g., a camera region 237) of the front plate 202 (e.g., front 200A of FIG. 1).

According to an embodiment, a second camera 212 (e.g., a rear camera) may be disposed between the frame structure 240 and the rear plate 211. According to an embodiment, the second camera 212 may be electrically connected to the first printed circuit board 250 through a connection member (e.g., a connector). According to an embodiment, the second camera 212 may be disposed so that the lens may receive external light through a camera region 284 of the rear plate 211 of the electronic device 101.

According to an embodiment, the camera region 284 may be formed on a surface (e.g., the rear surface 200B of FIG. 1) of the rear plate 211. According to an embodiment, the camera region 284 may be at least partially transparently formed so that external light may be incident on the lens of the second camera 212. According to an embodiment, at least a portion of the camera region 284 may protrude from the surface of the rear plate 211 to a predetermined height. However, it is not limited thereto, and in other embodiment, the camera region 284 may form substantially the same plane as the surface of the rear plate 211.

According to an embodiment, the housing (e.g., the housing 210 of FIG. 2A) of the electronic device 101 may mean a configuration or structure forming at least a portion of the exterior of the electronic device 101. In this respect, at least a portion of the front plate 202, the frame structure 240, and/or the rear plate 211 forming the exterior of the electronic device 101 may be referred to as the housing 210 of the electronic device 101.

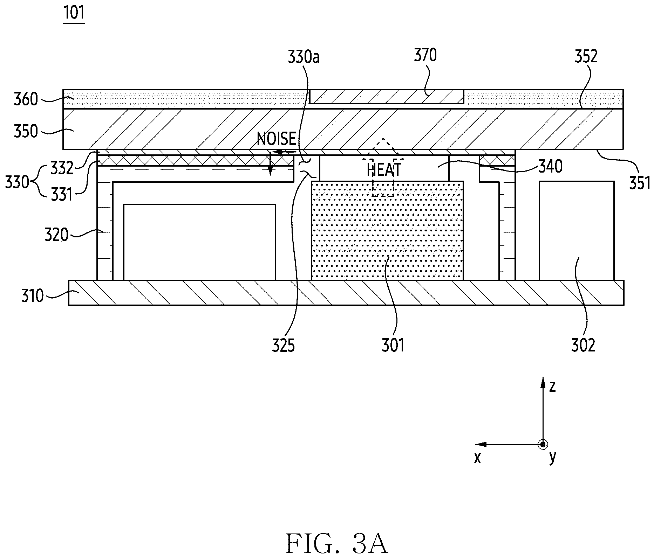

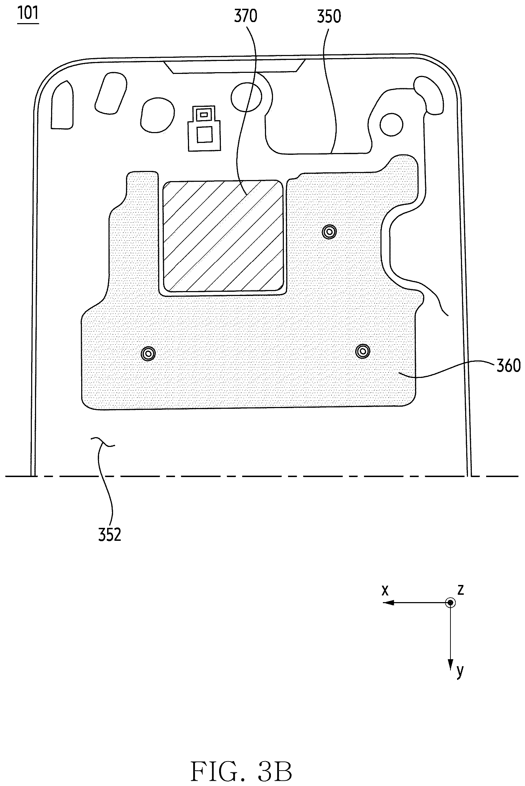

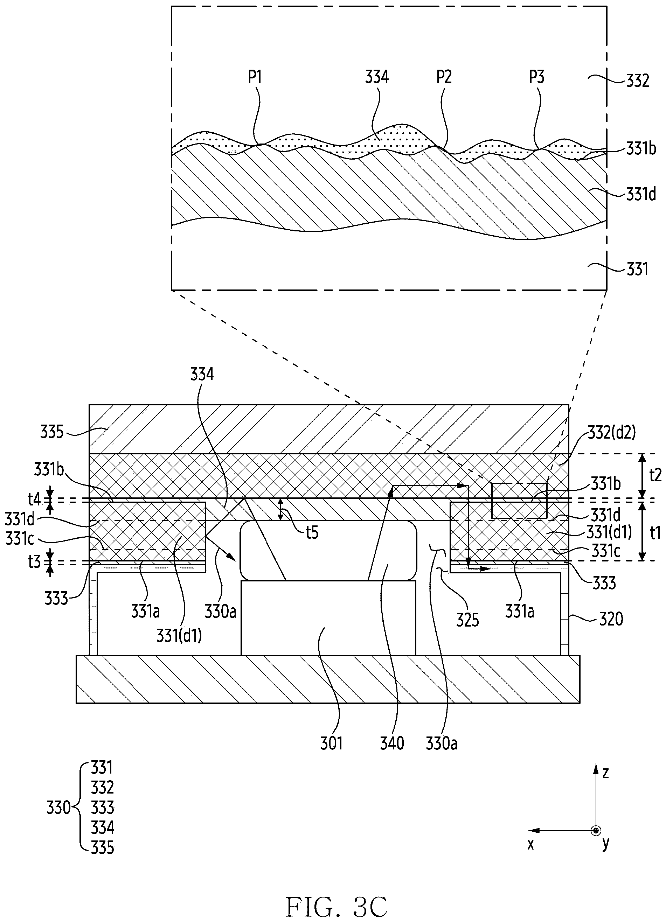

FIG. 3A is a partial cross-sectional view of an exemplary electronic device. FIG. 3B illustrates a portion of an exemplary electronic device. FIG. 3C illustrates a shielding structure of an electronic component of an exemplary electronic device.

Referring to FIGS. 3A, 3B, and 3C, the electronic device 101 may include a printed circuit board 310 (e.g., a first printed circuit board 250 and a second printed circuit board 252 of FIG. 2B), an electronic component 301, a shield can 320, a shielding structure 330, a heat conduction member 340, a metal plate 350, and/or at least one heat dissipating member 360. Henceforth, the combination of the metal plate 350 and the at least one heat dissipating member 360 may be referred to as a heat dissipating structure. That is, the electronic device 101 may comprise a printed circuit board 310 (e.g., a first printed circuit board 250 and a second printed circuit board 252 of FIG. 2B), an electronic component 301, a shield can 320, a shielding structure 330, a heat conduction member 340, and a heat dissipating structure. The heat dissipating structure may comprise a metal plate 350, and/or at least one heat dissipating member 360.

According to an embodiment, the electronic component 301 may be coupled on the printed circuit board 310. For example, the electronic component 301 may be disposed on the printed circuit board 310. For example, the electronic component 301 may be mounted on the printed circuit board 310. For example, the electronic component 301 may be electrically connected to the printed circuit board 310. For example, the electronic component 301 may be disposed on one surface of the printed circuit board 310 facing the display (e.g., the display 201 of FIG. 2A). For ease of reference, the surface of the printed circuit board 310 on which the electronic component 301 is disposed may be referred to as an upper surface of the printed circuit board 310. For example, the electronic component 301 may receive power from a power management module (e.g., a power management module 188 of FIG. 1) and/or a battery (e.g., a battery 189 of FIG. 1) of the electronic device 101 through the printed circuit board 310.

For example, the electronic component 301 may be a processor (for example, processor 120 of FIG. 1) of the electronic device 101. The electronic component 301 may emit heat while the electronic device 101 is operating. The electronic component 301 may emit electromagnetic waves while the electronic device 101 is operating. The electronic device 101 may require a structure to reduce the effect that other electronic components around the electronic component 301 malfunction or the performance of the other electronic components is deteriorated due to the heat and/or the electromagnetic waves emitted from the electronic component 301. Although it is described that the electronic component 301 may be the processor 120 of the electronic device 101, it is not limited thereto. The electronic component 301 may be referred to as a heating element in the electronic device 101 configured to emit heat or electromagnetic waves while the electronic device 101 is operating. That is, the electronic component 301 may be any component that emits electromagnetic radiation and/or heat.

According to an embodiment, the shield can 320 may be disposed on the printed circuit board 310. The shield can 320 may surround (or enclose) the electronic component 301. The shield can 320 may include an opening 325 facing the electronic component 301. That is, the shield can 320 may surround or enclose the electronic component 301 except for the opening 325. For example, the shield can 320 may be coupled on the printed circuit board 310. For example, the shield can 320 may be connected to the printed circuit board 310. For example, the shield can 320 may be attached to the printed circuit board 310. For example, the shield can 320 may be mounted on the printed circuit board 310 through at least one component (e.g., solder) between the shield can 320 and the printed circuit board 310. For example, the shield can 320 may be welded to the printed circuit board 310.

For example, the shield can 320 may be disposed on one surface (e.g. the upper surface) of the printed circuit board 310 on which the electronic component 301 is disposed. For example, the shield can 320 may shield at least a portion of the electronic component 301. For example, the shield can 320 may cover at least a portion of the electronic component 301. For example, the shield can 320 may surround at least a portion of the electronic component 301. For example, the shield can 320 may separate the electronic component 301 from other electronic component 302 around the electronic component 301 mounted on the printed circuit board 310.

Although it is described that the shield can 320 surrounds the electronic component 301, it is not limited thereto. The shield can 320 may surround a plurality of electronic components including the electronic component 301. By surrounding the plurality of the electronic components, the shield can 320 may separate a plurality of other electronic components distinguished from the plurality of the electronic components and including other electronic component 302 around the electronic component 301 from the plurality of the electronic components.

For example, the shield can 320 may be connected to a ground in the electronic device 101. For example, the shield can 320 may be electrically connected to the ground of the electronic device 101 through the printed circuit board 310. The shield can 320, by being connected to the ground, may emit electromagnetic waves emitted from the electronic component 301 to the ground. That is, electromagnetic radiation (or noise) emitted by the electronic component 301 may be transferred to the ground via the shield can 320. The shield can 320, by emitting the electromagnetic waves to the ground, may reduce performance degradation of other electronic component 302 around the electronic component 301 due to the electromagnetic waves. That is, the shield can 320 may prevent electromagnetic radiation (or noise) emitted by the electronic component from reaching the other electronic components 302.

For example, the opening 325 may penetrate the shield can 320. For example, the opening 325 may face the printed circuit board 310. That is, the opening 325 may be an opening in a plane of the shield can 320 that is substantially parallel to the plane of the printed circuit board 310. For example, the opening 325 may be formed in a portion of the shield can 320 facing the electronic component 301. For example, the opening 325 may overlap the electronic component 301 when viewing the printed circuit board 310 from above (e.g., when viewing the printed circuit board 310 in the -z direction). That is, the opening 325 may overlap the electronic component 301 in a direction perpendicular to the upper surface of the printed circuit board 310. For example, the opening 325 may pass a heat conduction member 340 attached on the electronic component 301. That is, the heat conduction member 340 attached to the electronic component 301 may be positioned and configured such that at least a portion of the heat conduction member 340 passes through the opening 325 in the shield can 320. For example, the opening 325 may be a path through which at least a portion of the heat emitted from the electronic component 301 is emitted through the heat conducting member 340 attached on the electronic component 301. That is, heat emitted by the electronic component 301 may be transferred outside of the space enclosed by the shield can 320 via the heat conducting member 340 disposed in the opening 325. Since the shield can 320 includes the opening 325 for emitting the heat from the electronic component 301, the shield can 320 may require a structure for shielding electromagnetic waves emitted from the electronic component 301 and passing through the opening 325. That is, by including the opening 325 in the shield can 320 in order to transfer heat out of the space enclosed by the shield can 320, the effectiveness of the shield can 320 at shielding other electronic components 302 from electromagnetic radiation (or noise) emitted by the electronic component 301 may be reduced. Therefore, the shielding structure 330 may additionally be included.

According to an embodiment, the shielding structure 330 may be disposed on the shield can 320. The shielding structure 330 may cover the opening 325 of the shield can 320. For example, the shielding structure 330 may be attached on the shield can 320. For example, the shielding structure 330 may be electrically connected to the shield can 320. For example, at least a portion of the shielding structure 330 may be in contact with the shield can 320. For example, the shielding structure 330 may be disposed between the shield can 320 and the metal plate 350.

For example, at least a portion of the shielding structure 330 may overlap the opening 325 of the shield can 320 when viewing the shielding structure 330 from above (e.g., when viewing the shielding structure 330 in the -z direction). That is, at least a portion of the shielding structure 330 may overlap the opening 325 in a direction perpendicular to the upper surface of the printed circuit board 310. For example, at least a portion of the shielding structure 330 may face the opening of the shield can 320. For example, at least a portion of the shielding structure 330 may be in contact with the heat conduction member 340 passing through the opening of the shield can 320. That is, a first end (or surface) of the heat conduction member 340 may be attached to the electronic component 301, and a second end (or surface), which may be opposite the first end (or surface) may be attached to the shielding structure 330 by passing through the opening 325. For example, at least a portion of the shielding structure 330 may face the electronic component 301 through the opening 325 of the shield can 320. For example, at least a portion of the shielding structure 330 may face at least a portion of the printed circuit board 310 through the opening 325 of the shield can 320. For example, the shielding structure 330 may seal the space between the shield can 320 and the printed circuit board 310 by covering the opening 325 of the shield can 320. That is, the combination of the shield can 320 and shielding structure 330 may completely enclose a space around the electronic component 301. For example, the shielding structure 330 may include a conductive material. Since the shielding structure 330 covers the opening 325 of the shield can 320, electromagnetic waves emitted from the electronic component 301 through the opening 325 may be reflected by the shielding structure 330 or transmitted to the shield can 320 in contact with the shielding structure 330 through the shielding structure 330. The electromagnetic waves transmitted to the shield can 320 through the shielding structure 330 may be emitted to the ground of the electronic device 101 connected to the shield can 320. By including the shielding structure 330 covering the opening 325, the electronic device 101 may provide a heat transfer path for heat dissipation of the electronic component 301 and shield electromagnetic waves passing through the opening 325.

According to an embodiment, the heat conduction member 340 may be attached on the electronic component 301. The heat conduction member 340 may be disposed between the electronic component 301 and the shielding structure 330. The heat conduction member 340 may be in contact with the shielding structure 330 through the opening 325 of the shield can 320. For example, the heat conduction member 340 may be in contact with the electronic component 301 and the shielding structure 330. For example, the heat conduction member 340 may be attached to the electronic component 301. For example, the heat conduction member 340 may transfer at least a portion of the heat emitted from the electronic component 301 to the shielding structure 330. For example, the heat conduction member 340 may transfer at least portion of the heat emitted from the electronic component 301 to the shielding structure 330 and/or metal plate 350 on the heat conduction member 340 through conduction heat transfer. For example, the heat conduction member 340 may be supported by an electronic component 301. For example, the heat conduction member 340 may be fastened between the shielding structure 330 and the electronic component 301 by being attached to the shielding structure 330.

For example, the heat conduction member 340 may penetrate at least a portion of the opening 325 of the shield can 320. For example, the heat conduction member 340 may be attached to the shielding structure 330 that covers the opening 325 by passing through the opening 325. For example, the heat conduction member 340 may provide a path for transferring heat emitted from the electronic component 301 to the shielding structure 330 through the opening 325. For example, the heat conduction member 340 may be extended from the electronic component 301 to the shielding structure 330 through the opening 325. For example, the heat conduction member 340 may include a material having a relatively high thermal conductivity. The heat conduction member 340 may be referred to as a thermal interface material (TIM) in that it is interposed between the electronic component 301 and the shielding structure 330, but is not limited thereto. The electronic device 101 may reduce performance degradation of the electronic component 301 surrounded by the shield can 320 due to the heat emitted from the electronic component 301 by including a heat conduction member 340 configured to dissipate at least a portion of the heat emitted from the electronic component 301 through the opening 325 of the shield can 320 to the shield structure 330 and/or the metal plate 350.

According to an embodiment, the heat dissipation structure may be disposed on the shielding structure 330. For example, the metal plate 350 or at least one heat dissipation member 360 may be disposed on the shielding structure 330 (e.g., in the z-axis direction). For example, the metal plate 350 may be attached to the shielding structure 330. For example, the metal plate 350 may be attached to the shield can 320 through the shielding structure 330. For example, the metal plate 350 may support the shielding structure 330. For example, the metal plate 350 may support the shield can 320 through the shielding structure 330. For example, the metal plate 350 may support the printed circuit board 310 and/or electronic component 301 on which the shield can 320 is disposed by supporting the shield structure 330 and/or the shield can 320. For example, the metal plate 350 may receive at least a portion of the heat emitted from the electronic component 301 through the heat conduction member 340 and the shielding structure 330. The metal plate 350 may reduce performance degradation of the electronic component 301 and/or the display 201 on the metal plate 350 due to the heat by diffusing at least a portion of the received heat. According to an embodiment, the metal plate 350 may be referred to as a structure (e.g., support structure 243 of FIG. 2B) that forms at least a portion of the frame structure (e.g., frame structure 240 of FIG. 2B) for supporting the display 201 of the electronic device 101, but is not limited thereto. For example, when referring to FIG. 2B together, the metal plate 350 may be the structure (e.g., cover plate 260) that supports the rear plate 211 opposite to the display 201. The electronic component 301, the shield can 320, and the shield structure 330 may be disposed on one surface of the printed circuit board 310 facing the rear plate 211. Heat emitted from the electronic component 301 may be transferred to the metal plate 350 supporting the rear plate 211 through the heat conduction member 340 and the shielding structure 330.

For example, the metal plate 350 may include a first surface 351 facing the shield can 320 and a second surface 352 opposite to the first surface 351. For example, the second surface 352 may be the surface facing the display 201 of the electronic device 101. For example, the first surface 351 may be the surface that presses the shielding structure 330 toward the shield can 320. By including the metal plate 350, the electronic device 101 may reduce the separation of the shield structure 330 from the shield can 320 and reduce performance degradation of the electronic component 301 and/or the display 201 due to the heat emitted from the electronic component 301.

According to an embodiment, at least one heat dissipation member 360 may be attached to the metal plate 350. The at least one heat dissipation member 360 may be configured to receive at least a portion of the heat emitted from the electronic component 301 through the heat conduction member 340. For example, at least one heat dissipation member 360 may cover at least a portion of the metal plate 350. For example, at least one heat dissipation member 360 may be in contact with the metal plate 350. For example, the at least one heat dissipation member 360 may be attached to the second surface 352 of the metal plate 350. The at least one heat dissipation member 360 may reduce performance degradation of the electronic component 301 and/or the display 201 on the at least one heat dissipation member 360 due to the heat, by dissipating at least a portion of heat emitted from the electronic component 301 with the metal plate 350.

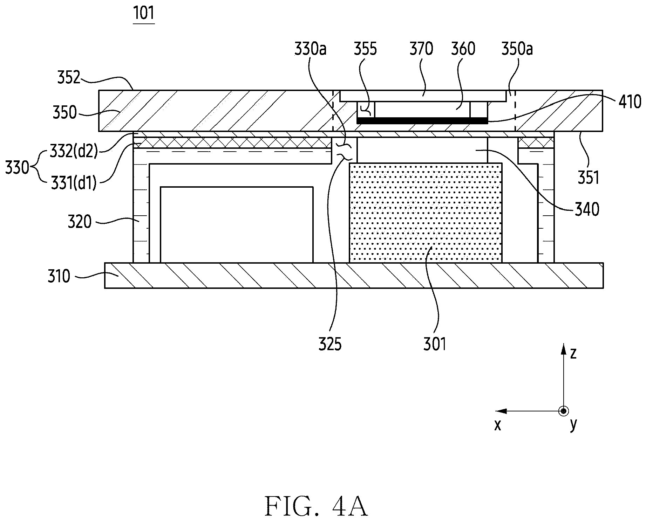

According to an embodiment, the electronic device 101 may further comprise a heat insulation member 370. The heat insulation member 370 may be attached to the metal plate 350. The insulation member 370 may overlap with the electronic component 301 when viewing the metal plate 350 from above (e.g., when viewing the metal plate 350 in the -z direction). That is, the heat insulation member 370 may at least partially overlap the electronic component 301 in a first direction perpendicular to the upper surface of the printed circuit board 310. For example, the heat insulation member 370 may be disposed on the electronic component 301. For example, the electronic device 101 may reduce performance degradation of the display 201 disposed on the metal plate 350 due to the heat emitted from the electronic component 301, by including the heat insulation member 370 disposed over the electronic component 301 and having relatively low thermal conductivity. According to an embodiment, the heat insulation member 370 may be surrounded by at least one heat dissipating member 360. What is related to the at least one heat dissipating member 360 and the heat insulation member 370 for dissipating and insulating heat emitted from the electronic component 301 will be described later in FIGS. 4A to 6.

According to an embodiment, the shielding structure 330 may include a first shielding member 331, a second shielding member 332, a first adhesive member 333, and a second adhesive member 334. The first shielding member 331 may be attached on the shield can 320. The first adhesive member 333 may be interposed between the first shielding member 331 and the shield can 320 to attach the first shielding member 331 to the shield can 320. The second shielding member 332 may be attached on the first shielding member 331. The second adhesive member 334 may be interposed between the first shielding member 331 and the second shielding member 332 to attach the second shielding member 332 to the first shielding member 331. In an embodiment, a density d1 of the first shielding member 331 is smaller than a density d2 of the second shielding member 332.

For example, a first shielding member 331 may be disposed between the shield can 320 and a second shielding member 332. For example, a first shielding member 331 may be interposed between the shield can 320 and a second shielding member 332. For example, a first shielding member 331 may be attached on the shield can 320 through a first adhesive member 333. For example, a first shielding member 331 may be fastened to the shield can 320 by a first adhesive member 333. For example, as illustrated in FIG. 3C, a first shielding member 331 may include a third surface 331a facing the shield can 320 and a fourth surface 331b opposite to the third surface 331a. The third surface 331a may be in contact with a first adhesive member 333. The fourth surface 331b may be in contact with a second adhesive member 334. For example, a third surface 331a of a first shielding member 331 may be covered (or partially covered) by a first adhesive member 333. A fourth surface 331b opposite to the third surface 331a may be covered (or partially covered) by a second adhesive member 334. For example, a first adhesive member 333 may be applied to a third surface 331a of a first shielding member 331. A second adhesive member 334 may be applied to a fourth surface 331b opposite to the third surface 331a.

For example, a second shielding member 332 may be disposed between a first shielding member 331 and the metal plate 350. For example, a second shielding member 332 may be attached on a first shielding member 331 through a second adhesive member 334. For example, a second shielding member 332 may be fastened to a first shielding member 331 through a second adhesive member 334.

For example, the shielding members 331 and 332 may include a conductive material. Since the shielding members 331 and 332 include conductive material, the shielding structure 330 may be configured to emit electromagnetic waves emitted from the electronic component 301 through the opening 325 of the shield can 320 to the ground of the electronic device 101 through the shield can 320 attached to the shielding structure 330. That is, electromagnetic radiation (or noise) emitted by the electronic component 301 into the opening 325 may be transferred to the ground via the connection between the shielding structure 330 and the shield can 320.

For example, the shielding members 331 and 332 may include voids in the shielding members 331 and 332. For example, the porosity of a first shielding member 331 may be greater than the porosity of a second shielding member 332. For example, the yarn thickness of a first shielding member 331 may be smaller than the yarn thickness of a second shielding member 332. For example, the air permeability of a first shielding member 331 may be greater than the air permeability of a second shielding member 332. For example, however, it is not limited. Since the density d1 of a first shielding member 331 is less than the density d2 of a second shielding member 332, it may provide a space in the first shielding member 331 for an adhesive material from a first adhesive member 333 and a second adhesive member 334 in contact with the first shielding member 331.

According to an embodiment, a first shielding member 331 may include a first region 331c including the adhesive material by a first adhesive member 333, and a second region 331d including the adhesive material by a second adhesive member 334. At least a portion of the fourth surface 331b of the first shielding member 331 facing the second shielding member 332 may be in contact with the second shielding member 332.

For example, a first shielding member 331 may include voids in the first shielding member 331. For example, a first adhesive member 333 may be pressed toward the first shielding member 331 by the shield can 320. At least a portion of the adhesive material of the first adhesive member 333 may be introduced into the voids in the first shielding member 331 through a third surface 331a of the first shielding member 331 by the pressing by the shield can 320. A first region 331c of the first shielding member 331 may be the region including the adhesive material introduced into the first shielding member 331 from the first adhesive member 333. For example, a second adhesive member 334 may be pressed toward the first shielding member 331 by the metal plate 350. At least a portion of the adhesive material of the second adhesive member 334 may be introduced into the voids in the first shielding member 331 through a fourth surface 331b of the first shielding member 331 by the pressing by the metal plate 350. A second region 331d of the first shielding member 331 may be the region including the adhesive material introduced into the first shielding member 331from the second adhesive member 334.

For example, the fourth surface 331b of the first shielding member 331 and/or the surface of the second shielding member 332 may be configured such that at least a portion of the fourth surface 331b of the first shielding member 331 makes direct contact with the surface of the second shielding member 332. For example, at least a portion of the adhesive material of a second adhesive member 334 is introduced into a second region 331d through a fourth surface 331b (for example through voids in the fourth surface 331b) of a first shielding member 331, thereby at least a portion of the fourth surface 331b facing a second shielding member 332 may be in contact with the second shielding member 332. For example, the shielding structure 330 may include points P1, P2, and P3 where a fourth surface 331b of a first shielding member 331 contacts with a second shielding member 332. As at least a portion of the fourth surface 331b contacts with the second shielding member 332, the shielding structure 330 may increase the shielding performance of the shielding structure 330 for shielding electromagnetic waves emitted from the electronic component 301 through the opening of the shield can 320.

Although it is described that the shielding structure 330 includes points P1, P2, and P3 where a fourth surface 331b contacts with a second shielding member 332, it is not limited thereto. The shielding structure 330 may include other points where a third surface 331a opposite to the fourth surface 331b contacts with the shield can 320. For example, the third surface 331a of the first shielding member 331 and/or the surface of the shield can 320 may be configured such that at least a portion of the third surface 331a of the first shielding member 331 makes direct contact with the surface of the shield can 320. For example, as at least a portion of the adhesive material of a first adhesive member 333 is introduced into a first region 331c through a third surface 331a (for example, though voids in the third surface 331a) of a first shielding member 331, at least a portion of the third surface 331a facing the shield can 320 may be in contact with the shield can 320. As at least a portion of the third surface 331a contacts with the shield can 320, the shielding structure 330 may increase the shielding performance of the shielding structure 330 for shielding electromagnetic waves emitted from the electronic component 301 through the opening of the shield can 320. The shielding structure 330 may increase the structural stability of structures (e.g., metal plate 350 and/or display 201) on the shielding structure 330 by including regions 331c and 331d configured to accommodate the adhesive material.

According to an embodiment, a thickness t1 of a first shielding member 331 may be located in a range of about 70 µm or more and 80 µm or less. The thickness t2 of a second shielding member 332 may be located in a range of about 10 µm or more and 20 µm or less. Since the thickness t1 of the first shielding member 331 is located in a range of about 70 µm or more and 80 µm or less, and the thickness t2 of the second shielding member 332 is located in a range of about 10 µm or more and 20 µm or less, the shielding structure 330 may increase the shielding performance of the shielding structure 330 for shielding the electronic component 301 and increase the structural stability of the structures (e.g., metal plate 350 and/or display 201) on the shielding structure 330.

According to an embodiment, the thickness t3 of a first adhesive member 333 and a first thickness t4 and a second thickness t5 of a second adhesive member 334 may each be located in a range of about 1 µm or more and 15 µm or less. For example, since at least a portion of the second adhesive member 334 may contacts with the heat conduction member 340 through a groove 330a of the shielding structure 330, a first thickness t4 of the portion disposed between a first shielding member 331 and a second shielding member 332 of a second adhesive member 334 may be less than a second thickness t5 of the portion disposed between the second shielding member 332 and the heat conduction member 340. The second thickness t5 may be located in a range of about 1 µm or more and 15 µm or less. Since the thickness t3 of the first adhesive member 333 and the first thickness t4 and the second thickness t5 of the second adhesive member 334 are each located in a range of about 1 µm or more and 15 µm or less, the shielding structure 330 may increase the shielding performance of the shielding structure 330 for shielding the electronic component 301 and increase the structural stability of the structures (e.g., metal plate 350 and/or display 201) on the shielding structure 330.

According to an embodiment, the heat conduction member 340 may include at least one of rubber, paraffin wax and oil. Since the heat conduction member 340 includes at least one of rubber, paraffin wax, and oil, the heat conduction member 340 may reduce repulsive force to structures (e.g., shielding structure 330, metal plate 350, or display 201) on the heat conduction member that pressurize the heat conduction member 340. The heat conduction member 340 may increase the structural stability of the structures by reducing the repulsive force to the structures.

According to an embodiment, the shielding structure 330 may further include a groove 330a dented toward the metal plate 350 from the opening 325 to accommodate the heat conduction member 340 penetrating at least a portion of the opening 325. That is, the shielding structure 330 may comprise an indentation in the surface facing the heat conduction member 340 to accommodate a portion of the heat conduction member 340. For example, the groove 330a may extend from the opening 325 to accommodate at least a portion of the heat conduction member 340 penetrating the opening 325 of the shield can 320. The groove 330a may be connected to the opening 325. For example, depth of the groove 330a may be substantially the same as the length of the heat conduction member 340 protruded toward the shielding structure 330 from the opening 325 in order to attach the heat conduction member 340 to the shielding structure 330. For example, the edges of the groove 330a may be aligned with the edges of the opening 325. For example, the inner surface of the groove 330a may be in contact with the heat conduction member 340. By including the groove 330a, the shielding structure 330 may provide a space for the heat conduction member 340 protruded through the opening 325 to the shielding structure 330 for shielding the opening 325 of the shield can 320.

According to an embodiment, a first shielding member 331 may surround at least a portion of the heat conduction member 340 passing through the opening 325. A second shielding member 332 may be attached on the heat conduction member 340 through a second adhesive member 334. For example, a first shielding member 331 may surround the heat conduction member 340 protruded toward the shielding structure 330 from the opening 325. For example, at least a portion of a first shielding member 331 may face a portion of the heat conduction member 340 passing through the opening 325. For example, a second shielding member 332 may cover the opening 325. By covering the opening 325, the second shielding member 332 may shield the space surrounded by a printed circuit board 310, the shield can 320, and the shielding structure 330. The second shielding member 332 may be attached on the heat conduction member 340 passing through the opening 325 through a second adhesive member 334.

For example, the groove 330a for accommodating the heat conduction member 340 protruded from the shield can 320 through the opening 325 may be formed by a first shielding member 331, a first adhesive member 333, and a second adhesive member 334 of the shielding structure 330. For example, the groove 330a may be formed in the first shielding member 331 and the first adhesive member 333. The first shielding member 331 and the first adhesive member 333 may surround the heat conduction member 340 passing through the opening 325. A second adhesive member 334 may be in contact with the heat conduction member 340 by covering the heat conduction member 340 passing through the opening 325. The second adhesive member 334 may attach the heat conduction member 340 to a second shielding member 332 by being contacted with the heat conduction member 340. The heat conduction member 340 may be configured to transfer at least a portion of the heat emitted from the electronic component 301 to the shielding structure 330 by contacting with the shielding structure 330.

According to an embodiment, the shielding structure 330 may further include a protection member 335. For example, the protection member 335 may be disposed on a surface of the shielding structure 330 that is opposite the surface of the shielding structure 330 that is in contact with the heat conduction member 340. The protection member 335 may be disposed on a second shielding member 332. For example, the protection member 335 may be stacked on a second shielding member 332. For example, the protection member 335 may be laminated to a second shielding member 332. For example, the protection member 335 may be attached on a second shielding member 332. For example, the protection member 335 may be disposed on a surface of the second shielding member 332 that is opposite the surface of the second shielding member 332 that is in contact with the second adhesive member 334. For example, the protection member 335 may be interposed between a second shielding member 332 and the metal plate 350. For example, the protection member 335 may include polyurethane, but is not limited thereto. The shielding structure 330, by including the protection member 335, may reduce performance degradation of the shielding structure 330 due to a structure (e.g., metal plate 350) on the shielding structure 330.

According to the above-described embodiment, by including the shield can 320, the electronic device 101 may reduce performance degradation of the other electronic components (e.g., other electronic component 302) around the electronic component 301 due to electromagnetic waves emitted from the electronic component 301. The electronic device 101 may reduce performance degradation of the electronic component 301 due to heat emitted from the electronic component 301, by including the heat conduction member 340 passing through the opening 325 of the shield can 320 and attached to the electronic component 301. By including the shielding structure 330 covering the opening 325, the electronic device 101 may reduce performance degradation of the other electronic components around the electronic component 301 due to electromagnetic waves emitted from the electronic component 301 through the opening 325. Since the density d1 of a first shielding member 331 attached to the shield can 320 is lower than the density d2 of a second shielding member 332 attached to the first shielding member 331, the shielding structure 330 may increase the shielding performance of the shielding structure 330 for the electromagnetic waves emitted from the electronic component 301 through the opening 325. The electronic device 101 may reduce performance degradation of the electronic device 101 due to heat emitted from the electronic component 301, by including a metal plate 350 disposed on the shielding structure 330 and at least one heat dissipation member 360.

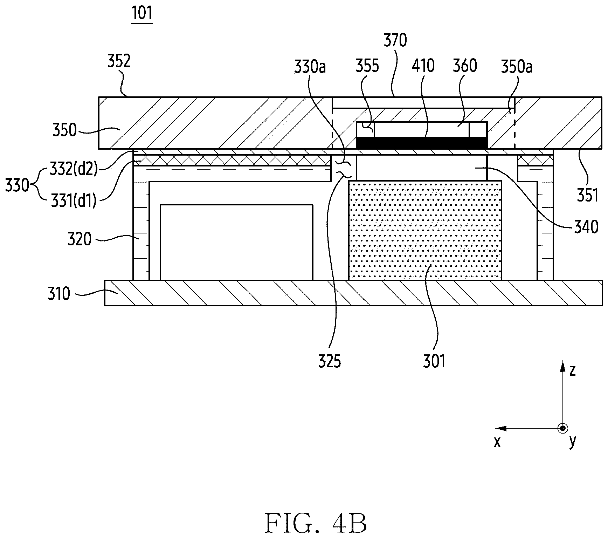

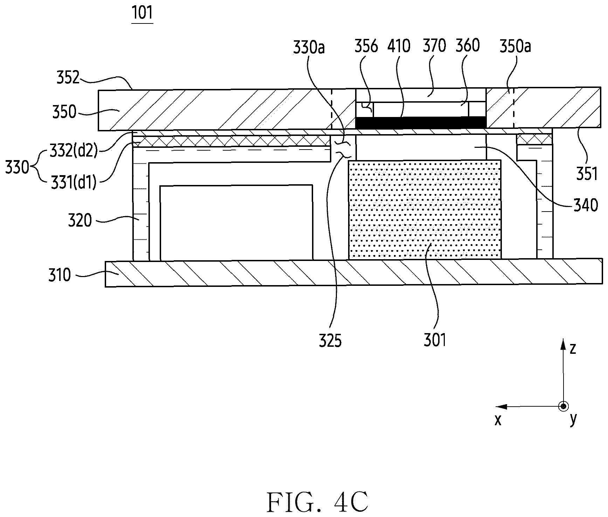

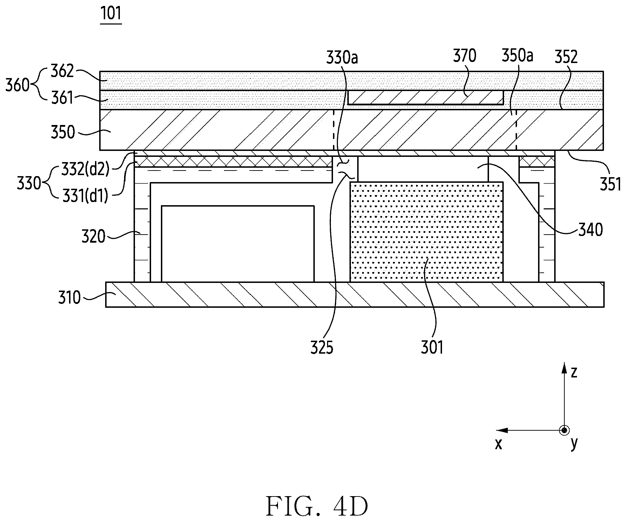

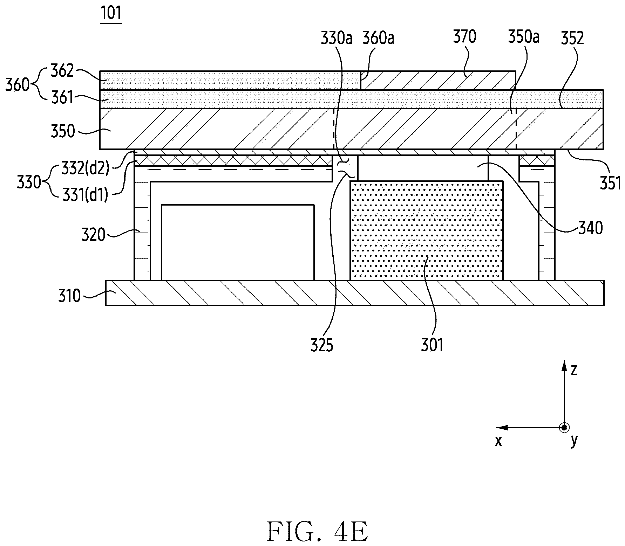

FIGS. 4A, 4B, 4C, 4D, and 4E are partial cross-sectional view of the exemplary electronic device.

Referring to FIGS. 4A, 4B, 4C, 4D, and 4E, an electronic device 101 may include a printed circuit board 310 (e.g., a first printed circuit board 250 and a second printed circuit board 252 of FIG. 2B), an electronic component 301 coupled on the printed circuit board 310, and a shield can 320 on the printed circuit board 310 surrounding the electronic component 301 and including an opening 325 facing the electronic component 301. The electronic device 101 may include a shielding structure 330 on the shield can 320 covering the opening 325 and a heat conduction member 340 between the electronic component 301 and the shielding structure 330 attached on the electronic component 301 and contacting with the shielding structure 330 through the opening 325. The electronic device 101 may include a metal plate 350 on the shielding structure 330 and at least one heat dissipation member 360 attached to the metal plate 350 and configured to receive at least a portion of heat emitted from the electronic component through the heat conduction member 340. In an embodiment, the shielding structure 330 may include a first shielding member 331 attached on the shield can 320, a first adhesive member (e.g., a first adhesive member 333 of FIG. 3C) interposed between the first shielding member 331 and the shield can 320 to attach the first shielding member 331 to the shield can 320, a second shielding member 332 attached on the first shielding member 331 and a second adhesive member (e.g., a second adhesive member 334 of FIG. 3C) interposed between the first shielding member 331 and the second shielding member 332 to attach the second shielding member 332 to the first shielding member 331. For example, a density d1 of the first shielding member 331 may be smaller than a density d2 of the second shielding member 332. According to an embodiment, the shielding structure 330 may further include a groove 330a dented toward the metal plate 350 from the opening 325 to accommodate the heat conduction member 340 penetrating at least a portion of the opening 325.

Hereinafter, redundant description of the configuration described in FIGS. 3A to 3C will be omitted. It should be understood that all features described above in relation to FIGS. 3A to 3C (e.g. protection member 335, first region 331c, second region 331d, etc.) may be combined with the embodiments described below, even if not illustrated in FIGS. 4A, 4B, 4C, 4D, and 4E.

According to an embodiment, the metal plate 350 may include the heat dissipation portion 350a disposed above the electronic component 301. For example, the heat dissipation portion 350a may overlap the electronic component 301 when viewing the metal plate 350 from above (e.g., when viewing the metal plate 350 in the -z direction). For example, the heat dissipation portion 350a may be configured to at least partially overlap the electronic component 301 in a first direction perpendicular to the upper surface of the printed circuit board 310. For example, the heat dissipation portion 350a may be located on the heat conduction member 340. For example, the heat dissipation portion 350a may overlap the opening 325 of the shield can 320 when viewing the metal plate 350 from above (e.g., when viewing the metal plate 350 in the -z direction). For example, the heat dissipation portion 350a may be located on a portion of the shielding structure 330 covering the opening 325 of the shield can 320. The electronic device 101 may require a structure for dissipating heat transferred from the electronic component 301 to the heat dissipation portion 350a of the metal plate 350 through the heat conduction member 340 and the shielding structure 330 to reduce performance degradation of the electronic device 101 due to the heat emitted from the electronic component 301.

According to an embodiment, at least one heat dissipation member 360 may include at least one of vapor chamber, heat pipe, graphite, and graphene. Since the at least one heat dissipation member 360 includes at least one of the vaper chamber, the heat pipe, the graphite, and the graphene, the at least one heat dissipation member 360 attached to the metal plate 350 may dissipate heat transferred from the electronic component 301 to the metal plate 350. By dissipating the heat, the at least one heat dissipation member 360 may reduce performance degradation of the electronic device 101 due to the heat.

Referring to FIGS. 4A, 4B, and 4C, in an embodiment, the metal plate 350 may include a recess or a through hole, wherein the recess or the through hole is configured to at least partially overlap the electronic component 301 in a first direction perpendicular to the upper surface of the printed circuit board 310. The at least one heat dissipation member 360 may be disposed in the recess or the through hole. For example, the recess may be formed in a first surface 351 of the metal plate 350 facing the shield can 320, or the recess may be formed in a second surface 352 of the metal plate 350 opposite to the first surface 351. For example, the through hole may extend from the first surface 351 of the metal plate 350 to the second surface 352 of the metal plate 350.

Referring to FIG. 4A, in an embodiment, the metal plate 350 may include a recess 355 indented toward the heat conduction member 340 from a second surface 352 of the metal plate 350 opposite to a first surface 351 of the metal plate 350 facing the shield can 320. That is, the metal plate 350 may comprise an indentation in the second surface 352 (i.e. in the surface opposite to the surface that faces the shielding structure 330). The at least one heat dissipation member 360 is disposed in the recess 355 so that it overlaps the electronic component 301 when viewing the metal plate 350 from above (e.g., when viewing in the -z direction).

For example, the recess 355 may be indented from a second surface 352 of the metal plate 350 toward a first surface 351 opposite to the second surface 352. For example, the recess 355 may overlap the electronic component 301 when viewing the metal plate 350 from above (e.g., when viewing the metal plate 350 in the -z direction). For example, the recess 355 may be configured to at least partially overlap the electronic component 301 in a first direction perpendicular to the upper surface of the printed circuit board 310. For example, the recess 355 may be formed in the heat dissipation portion 350a of the metal plate 350. For example, the recess 355 may be disposed to overlap the heat conduction member 340. For example, the recess 355 may accommodate at least one heat dissipation member 360. For example, at least one heat dissipation member 360 may be attached on the heat conduction member 340 by being disposed in the recess 355. The metal plate 350 may reduce performance degradation of the electronic device 101 due to heat emitted from the electronic component 301, by including the recess 355 for accommodating at least one heat dissipation member 360.

According to an embodiment, the electronic device 101 may further include another heat conduction member 410 disposed to face the electronic component 301 in the recess 355 of the metal plate 350 and distinguished from the heat conduction member 340 attached to the electronic component 301. For example, another heat conduction member 410 may be disposed between the inner surface of the recess 355 and at least one heat dissipation member 360. The electronic device 101 may reduce performance degradation of the electronic device 101 due to heat emitted from the electronic component 301 by further including the metal plate 350 and another heat conduction member 410 contacting with the at least one heat dissipation member 360. According to an embodiment, the heat conduction member 340 attached on the electronic component 301 may have a pad shape. Unlike the heat conduction member 340, the other heat conduction member 410 disposed in the recess 355 may be disposed to be applied to at least a portion of the inner surface of the recess 355. However, it is not limited thereto.

According to an embodiment, the electronic device 101 may further include an insulation member 370 covering the recess 355 in which at least one heat dissipation member 360 is disposed. The heat insulation member 370 may be attached to the at least one heat dissipation member 360. For example, the heat insulation member 370 may be supported by at least one heat dissipation member 360. By including an insulating structure covering the recess 355, the electronic device 101 may reduce performance degradation of a display (e.g., a display 201 of FIG. 2A) of the electronic device 101 disposed on the insulation member 370 due to the heat transferred to at least one heat conduction member 360 in the recess 355 from the electronic component 301.

Referring to FIG. 4B, in an embodiment, unlike FIG. 4A, a recess 355 of a metal plate 350 may be indented toward a second surface 352 opposite to the first surface 351 from a first surface 351 facing the shield can 320 of the metal plate 350. That is, the metal plate 350 may comprise an indentation in the first surface 351 (i.e. in the surface that faces the shielding structure 330). At least one heat dissipation member 360 may be disposed in the recess 355. According to an embodiment, an electronic device 101 may further include the other heat conduction member 410 disposed in the recess 355 and distinguished from a heat conduction member 340 attached to an electronic component 301. The other heat conduction member 410 may be disposed between at least one heat dissipation member 360 and a shielding structure 330. By being contacted with the shielding structure 330 and the at least one heat dissipation member 360, the other heat conducting member 410 may reduce performance degradation of the electronic device 101 due to heat emitted from the electronic component 301.

According to an embodiment, the heat insulation member 370 may be attached on a second surface 352 opposite to a first surface 351 where the recess 355 is formed. For example, the metal plate 350 may include another recess indented toward the first surface 351 from the second surface 352 to accommodate the heat insulation member 370. That is, the metal plate 350 may also comprise an indentation in the second surface 352 (i.e. in the surface opposite to the surface that faces the shielding structure 330). For example, the heat insulation member 370 may overlap the recess 355 for accommodating at least one heat dissipation member 360 when viewing from above (e.g., when viewing in the -z direction). For example, the heat insulation member 370 may be disposed above at least one heat dissipation member 360. The electronic device 101 may reduce performance degradation of the electronic device 101 due to the heat emitted from the electronic component 301 by including the heat insulation member 370 attached on a second surface 352.

Referring to FIG. 4C, in an embodiment, unlike FIGS. 4A and 4B, the metal plate 350 may further include a through hole 356 formed in the heat dissipation portion 350a. For example, the through hole 356 may be extended from a first surface 351 facing the shield can 320 of the metal plate 350 to a second surface 352 opposite to the first surface 351. For example, the through hole 356 may overlap the electronic component 301 when viewing the metal plate 350 from above (e.g., when viewing the metal plate 350 in the -z direction). For example, the through hole 356 may be configured to at least partially overlap the electronic component 301 in a first direction perpendicular to the upper surface of the printed circuit board 310.

According to an embodiment, at least one heat dissipation member 360 may be disposed inside the through hole 356. The electronic device 101 may further include other heat conduction member 410 disposed inside the through hole 356 and distinguished from the heat conduction member 340 attached to the electronic component 301. The other heat conduction member 410 may be disposed between at least one heat dissipation member 360 and the shielding structure 330.

According to an embodiment, the electronic device 101 may further include a heat insulation member 370 covering the through hole 356. The heat insulation member 370 may be in contact with at least one heat dissipation member 360 disposed in the through hole 356. The electronic device 101 may reduce performance degradation of the electronic device 101 due to heat emitted from the electronic component 301 by including the heat insulation member 370 covering the through hole 356.

Referring to FIG. 4D, in an embodiment, at least one heat dissipation member 360 may include a first heat dissipation member 361 covering at least a part of a second surface 352 of the metal plate 350 opposite to a first surface 351 facing a shield can 320 of the metal plate 350. For example, the electronic device 101 may further include the heat insulation member 370 disposed over a heat dissipation portion 350a of the metal plate 350 and at least partially surrounded by the first heat dissipation member 361. For example, a first heat dissipation member 361 may be attached on a second surface 352 of the metal plate 350. The heat insulation member 370 may be surrounded by the first heat dissipation member 361 attached to the second surface 352, and may be disposed above the heat dissipation portion 350a of the metal plate 350. That is, the heat insulation member 370 may be configured to at least partially overlap the heat dissipation portion 350a in a first direction perpendicular to the upper surface of the printed circuit board 310. The first heat dissipation member 361 may surround at least a portion of the heat insulation member 370. For example, the heat insulation member 370 may be in contact with a first heat dissipation member 361. For example, at least a portion of the first heat dissipation member 361 may be interposed between the heat insulation member 370 and the heat dissipation portion 350a of the metal plate 350. For example, by being attached to (or overlapping) the heat dissipation portion 350a disposed on an electronic component 301, the heat insulation member 370 may reduce heat transfer from the electronic component 301 to the direction in which the electronic device 101 faces the heat dissipation portion 350a (e.g., the +z direction). By reducing the heat transfer, the heat insulation member 370 may reduce performance degradation of the component (e.g., display 201) of the electronic device 101 disposed on the heat insulation member 370. The electronic device 101 may reduce performance degradation of the electronic device 101 due to heat emitted from the electronic component 301 by including a first heat dissipation member 361 on a second surface 352 of the metal plate 350 and the heat insulation member 370 at least partially surrounded by the first heat dissipation member 361.

According to an embodiment, at least one heat dissipation member 360 may further include a second heat dissipation member 362 disposed on a first heat dissipation member 361 and the heat insulation member 370 and covering the heat insulation member 370. For example, a second heat dissipation member 362 may cover at least a portion of the heat insulation member 370 and a first heat dissipation member 361. For example, a second heat dissipation member 362 may be contacted with the heat insulation member 370. By including a second heat dissipation member 362, the electronic device 101 may dissipate the heat transferred to the insulation member 370 and/or a first heat dissipation member 361 from the electronic component 301 through the metal plate 350. By dissipating the heat, the second heat dissipation member 362 may reduce performance degradation of the electronic device 101 due to the heat.

Referring to FIG. 4E, at least one heat dissipation member 360 may further include a step structure 360a for accommodating a heat insulation member 370. For example, the heat insulation member 370 may be disposed at the step structure 360a. The step structure 360a may be formed above the heat dissipation portion 350a of the metal plate 350. The insulation member 370 may overlap the heat dissipation portion 350a when viewing the metal plate 350 from above (e.g., viewing the metal plate in the -z direction). By including the step structure 360a, the at least one heat dissipation member 360 may provide a space in which the heat insulation member 370, for heat emitted to the heat dissipation portion 350a from the electronic component 301, is disposed.

According to an embodiment, at least one heat dissipation member 360 may include a first heat dissipation member 361 and a second heat dissipation member 362 attached to the first heat dissipation member 361 to form the step structure 360a. For example, length of a second heat dissipation member 362 disposed on a first heat dissipation member 361 may be smaller than length of the first heat dissipation member 361. Since the length of the second heat dissipation member 362 is smaller than the length of the first heat dissipation member 361, at least one heat dissipation member 360 may provide the step structure 360a for the heat insulation member 370 to be disposed.

According to the above-described embodiment, the electronic device 101 may reduce heat transfer from the electronic component 301 to the direction facing the heat dissipation portion 350a (e.g., +z direction) by including the heat insulation member 370 disposed on (or overlapping) the heat dissipation portion 350a of the metal plate 350. The electronic device 101 may dissipate heat emitted from the electronic component 301 by including at least one heat dissipation member 360 around the heat insulation member 370. The electronic device 101 may reduce performance degradation of the electronic device 101 due to heat emitted from the electronic component 301 by including the at least one heat dissipation member 360 and the heat insulation member 370.

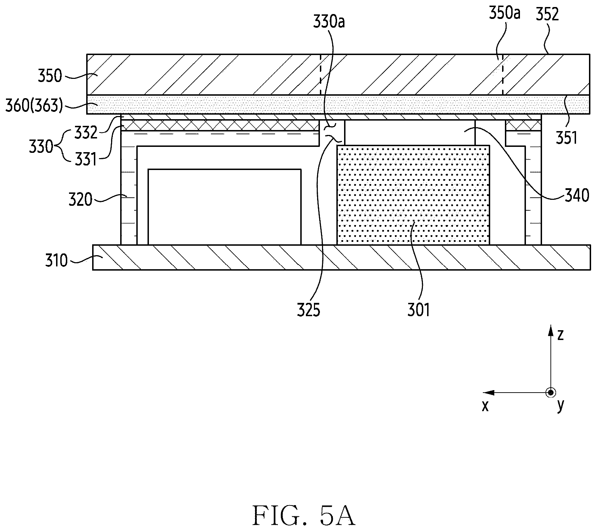

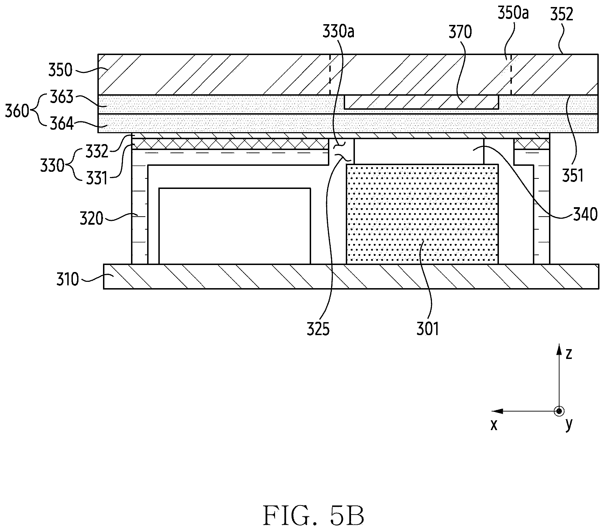

FIGS. 5A and 5B are partial cross-sectional view of the exemplary electronic device.

Referring to FIGS. 5A and 5B, an electronic device 101 may include a printed circuit board 310 (e.g., a first printed circuit board 250 and a second printed circuit board 252 of FIG. 2B), an electronic component 301, a shield can 320, a shielding structure 330, a heat conduction member 340, a metal plate 350, and at least one heat dissipation member 360. According to an embodiment, the metal plate 350 may include a heat dissipation portion 350a disposed above the electronic component 301. That is, the heat dissipation portion 350a may be configured to at least partially overlap the electronic component 301 in a first direction perpendicular to the upper surface of the printed circuit board 310.

According to an embodiment, at least one heat dissipation member 360 may include at least one of vapor chamber, heat pipe, graphite, and graphene.

Hereinafter, redundant description of the configuration described in FIGS. 3A to 3C will be omitted. It should be understood that all features described above in relation to FIGS. 3A to 3C (e.g. protection member 335, first region 331c, second region 331d, etc.) may be combined with the embodiments described below, even if not illustrated in FIGS. 5A and 5B.

Referring to FIG. 5A, at least one heat dissipation member 360 may include a third heat dissipation member 363 covering at least a portion of a first surface 351 of the metal plate 350 facing the shield can 320 and attached to the shielding structure 330. For example, the third heat dissipation member 363 may be disposed between the shielding structure 330 and the metal plate 350. For example, the third heat dissipation member 363 may be attached on a first surface 351 of the metal plate 350. The third heat dissipation member 363 may reduce performance degradation of the electronic device 101 due to the heat transferred to the third heat dissipation member 363 by dissipating the heat transferred to the third heat dissipation member 363 from the electronic component 301 through the heat conduction member 340.

Referring to FIG. 5B, an electronic device 101 may further include a heat insulation member 370 at least partially surrounded by a third heat dissipation member 363. The heat insulation member 370 may be attached to a heat dissipation portion 350a of a metal plate 350. At least one heat dissipation member 360 may further include a fourth heat dissipation member 364 disposed on the third heat dissipation member 363 and the heat insulation member 370 and covering the heat insulation member 370.

For example, the heat insulation member 370 may be disposed on a first surface of the metal plate 350 and attached to the heat dissipation portion 350a of the metal plate 350. A third heat dissipation member 363 may surround at least a portion of the heat insulation member 370. For example, the heat insulation member 370 may be in contact with a third heat dissipation member 363. For example, at least a portion of the third heat dissipation member 363 may be interposed between the heat insulation member 370 and the fourth heat dissipation member 364. For example, by being attached to the heat dissipation portion 350a disposed on an electronic component 301, the heat insulation member 370 may reduce heat transfer from the electronic component 301 to the direction in which the electronic device 101 faces the heat dissipation portion 350a (e.g., the +z direction). By reducing the heat transfer, the heat insulation member 370 may reduce performance degradation of the component (e.g., display 201) of the electronic device 101 disposed on the heat insulation member 370. The electronic device 101 may reduce performance degradation of the electronic device 101 due to heat emitted from the electronic component 301 by including a third heat dissipation member 363 of a first surface 351 of the metal plate 350 and the heat insulation member 370 at least partially surrounded by the third heat dissipation member 363.

For example, a fourth heat dissipation member 364 may cover at least a portion of a third heat dissipation member 363. For example, Although not illustrated, a fourth heat dissipation member 364 may be contacted with the heat insulation member 370 and a shielding structure 330. By including a fourth heat dissipation member 364, the electronic device 101 may dissipate heat transferred to a fourth heat dissipation member 364 from the electronic component 301 through the shielding structure 330. By dissipating the heat, a fourth heat dissipation member 364 may reduce performance degradation of the electronic device 101 due to the heat.

According to an embodiment, a third heat dissipation member 363 and a fourth heat dissipation member 364 may be formed as one body. The heat insulation member 370 may be surrounded by the heat dissipation member 360 on a first surface 351 integrally formed. The heat insulation member 370 may be covered by the metal plate 350. However, it is not limited to thereto. According to an embodiment, unlike the illustration in FIG. 5B, a fourth heat dissipation member 364 may be omitted. A third heat dissipation member 363 may be attached to the shielding structure 330.

According to the above-described embodiment, the electronic device 101 may reduce heat transfer from the electronic component 301 to the direction (e.g., +z direction) facing the heat dissipation portion 350a by including the heat insulation member 370 attached to the heat dissipation portion 350a of the metal plate 350. The electronic device 101 may dissipate heat emitted from the electronic component 301 by including at least one heat dissipation member 360 around the heat insulation member 370. The electronic device 101 may reduce performance degradation of the electronic device 101 due to the heat emitted from the electronic component 301 by including the at least one heat dissipation member 360 and the heat insulation member 370.

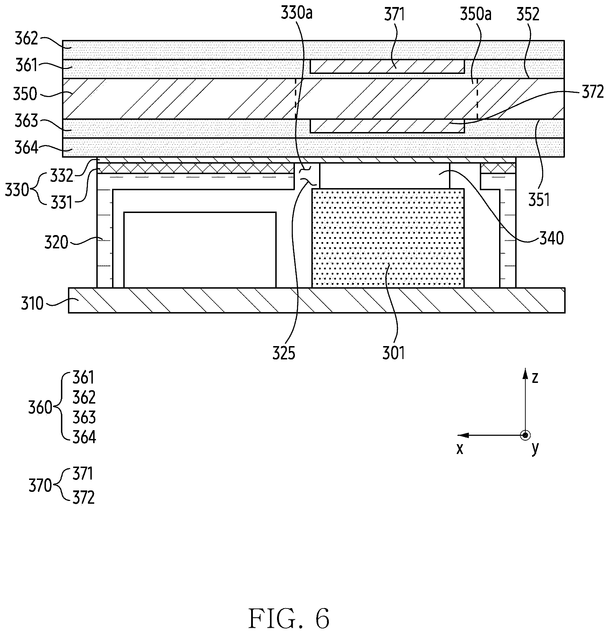

FIG. 6 is a partial cross-sectional view of the exemplary electronic device.

Referring to FIG. 6, an electronic device 101 may include a printed circuit board 310 (e.g., a first printed circuit board 250 and a second printed circuit board 252 of FIG. 2B), an electronic component 301, a shield can 320, a shielding structure 330, a heat conduction member 340, a metal plate 350, and at least one heat dissipation member 360. According to an embodiment, the metal plate 350 may include a heat dissipation portion 350a disposed on (or above) the electronic component 301. That is, the heat dissipation portion 350a may be configured to at least partially overlap the electronic component 301 in a first direction perpendicular to the upper surface of the printed circuit board 310. Hereinafter, redundant description of the configuration described in FIGS. 3A to 3C will be omitted. It should be understood that all features described above in relation to FIGS. 3A to 3C (e.g. protection member 335, first region 331c, second region 331d, etc.) may be combined with the embodiments described below, even if not illustrated in FIG. 6.

According to an embodiment, at least one heat dissipation member 360 may include at least one of vapor chamber, heat pipe, graphite, and graphene.

According to an embodiment, the heat insulation member 370 may include a first heat insulation member 371 and a second heat insulation member 372. At least one heat dissipation member 360 may include a first heat dissipation member 361, a second heat dissipation member 362, a third heat dissipation member 363, and/or a fourth heat dissipation member 364.

For example, a first heat dissipation member 371 may be disposed on a second surface 352 facing a display (e.g., a display 201 of FIG. 2A) of the metal plate 350. For example, a first heat insulation member 371 may be disposed above the second surface 352. For example, the first heat insulation member 371 may be configured to at least partially overlap the electronic component 301 in a first direction perpendicular to the upper surface of the printed circuit board 310. The first heat insulation member 371 may be at least partially surrounded by the first heat dissipation member 361. For example, the first heat insulation member 371 may be, although not illustrated, attached to the heat dissipation portion 350a of the metal plate 350. For example, at least a portion of the first heat dissipation member 361 may be interposed between the first heat insulation member 371 and the heat dissipation portion 350a. A second heat dissipation member 362 may be attached on the first heat dissipation member 361 and the first heat insulation member 371. The second heat dissipation member 362 may be disposed between the first heat dissipation member 361 and the display 201. The second heat dissipation member 362 may cover the first heat insulation member 371.

For example, a third heat dissipation member 363 may be disposed on a first surface 351 facing the shield can 320 of the metal plate 350. A second heat insulation member 372 may be disposed on the first surface 351. The second heat insulation member 372 may be at least partially surrounded by the third heat dissipation member 363. The second heat insulation member 372 may be attached to the heat dissipation portion 350a of the metal plate 350. A fourth heat dissipation member 364 may be attached on the third heat dissipation member 363 and the second heat insulation member 372. For example, at least a portion of the third heat dissipation member 363 may be interposed between the second heat insulation member 372 and the fourth heat dissipation member 364. The fourth heat dissipation member 364 may be disposed between the third heat dissipation member 363 and the shielding structure 330. The second heat insulation member 372 may be covered by the metal plate 350.

According to the above-described embodiment, the electronic device 101 may reduce heat transfer from the electronic component 301 to the direction (e.g., +z direction) facing the heat dissipation portion 350a by including the heat insulation member 370 disposed at the heat dissipation portion 350a of the metal plate 350. The electronic device 101 may dissipate heat emitted from the electronic component 301 by including at least one heat dissipation member 360 around the heat insulation member 370. The electronic device 101 may reduce performance degradation of the electronic device 101 due to the heat emitted from the electronic component 301 by including the at least one heat dissipation member 360 and the heat insulation member 370.

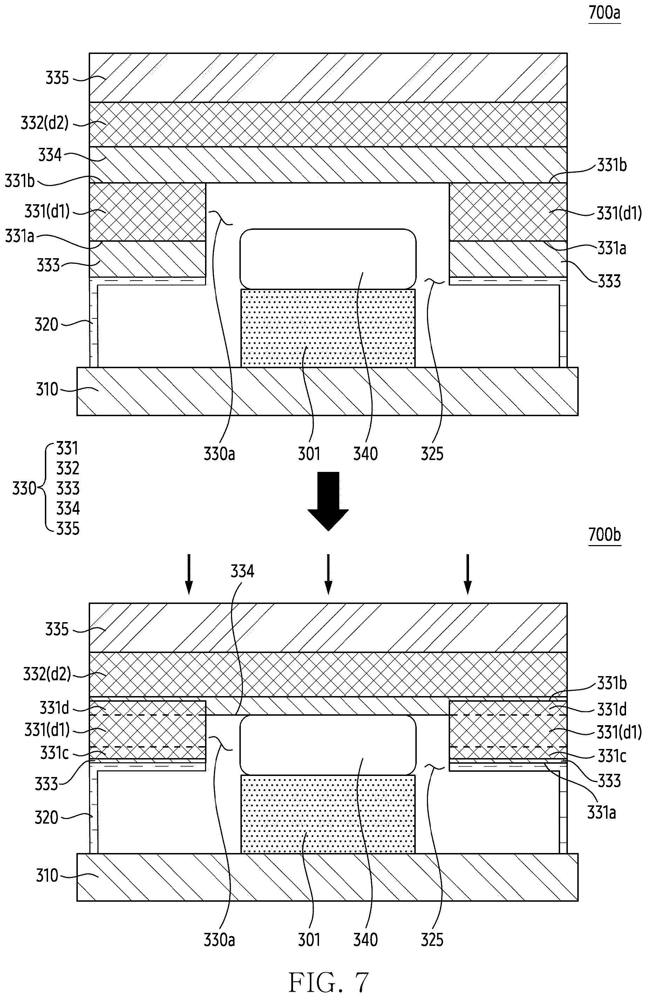

FIG. 7 illustrates a lamination process of the shielding structure of the exemplary electronic device.

Referring to FIG. 7, an electronic device (e.g., an electronic device 101 of FIG. 1) may include a printed circuit board 310 (e.g., a first printed circuit board 250 and a second printed circuit board 252 of FIG. 2B), an electronic component 301 coupled on the printed circuit board 310, and a shield can 320 on the printed circuit board 310 surrounding the electronic component 301 and including an opening 325 facing the electronic component 301. The electronic device 101 may include a shielding structure 330 on the shield can 320 covering the opening 325 and a heat conduction member 340 between the electronic component 301 and the shielding structure 330 attached on the electronic component 301 and contacting with the shielding structure 330 through the opening 325. The shielding structure 330 may include a first shielding member 331 attached on the shield can 320, a first adhesive member interposed between the first shielding member 331 and the shield can 320 to attach the first shielding member 331 to the shield can 320, a second shielding member 332 attached on the first shielding member 331 and a second adhesive member interposed between the first shielding member 331 and the second shielding member 332 to attach the second shielding member 332 to the first shielding member 331. For example, a density d1 of the first shielding member 331 may be smaller than a density d2 of the second shielding member 332. According to an embodiment, the shielding structure 330 may further include a groove 330a indented toward the metal plate 350 from the opening 325 to accommodate the heat conduction member 340 penetrating at least a portion of the opening 325.

Referring to step 700a, the shielding structure 330 may be attached on the shield can 320. The members 331, 332, 333, 334, and 335 in the shielding structure 330 may be laminated to each other in the shielding structure 330. For example, a first shielding member 331 may be stacked on a first adhesive member 333. A second adhesive member 334 may be stacked on the first shielding member 331. A second shielding member 332 may be stacked on the second adhesive member 334. A protection member 335 may stacked on the second shielding member 332. The first shielding member 331 may be attached to the shield can 320 by being laminated on the first adhesive member 333. The second shielding member 332 may be attached to the first shielding member 331 by being laminated on the second adhesive member 334.

Referring to step 700b, the shielding structure 330 may be pressed in a direction (e.g., - z direction) toward the printed circuit board 310. The shielding structure 330 may be pressed toward the shield can 320 by the metal plate (e.g., a metal plate 350 of FIG. 3A). For example, since a first shielding member 331 includes voids, at least a portion of a first adhesive member 333 between the first shielding member 331 and the shield can 320 may introduced into the voids in the first shielding member 331 through a third surface 331a facing the shield can 320 of the first shielding member 331. A first region 331c of the first shielding member 331 may be formed by introducing an adhesive material from the first adhesive member 333 to the first shielding member 331 by pressing applied to the shielding structure 330. At least a portion of the third surface 331a of the first shielding member 331 may be contacted with the shield can 320. For example, since the first shielding member 331 includes the voids and a density d1 of the first shielding member 331 is less than a density d2 of a second shielding member 332, at least a portion of a second adhesive member 334 between the first shielding member 331 and a second shielding member 332 may be introduced into the voids in the first shielding member 331 through a fourth surface 331b facing the second shielding member 332 of the first shielding member 331. A second region 331d of the first shielding member 331 may be formed by introducing an adhesive material from the second adhesive member 334 to the first shielding member 331 by pressing applied to the shielding structure 330. At least a portion of the fourth surface 331b of the first shielding member 331 may be contacted with the second shielding member 332. At least a portion of the second adhesive member 334 may be moved toward the printed circuit board 310 with the second shielding member 332 by the pressing. The second adhesive member 334 moved toward the printed circuit board 310 may be attached to the heat conduction member 340. That is, the shielding structure 330 and shield can 320 may be pressed together such that the second adhesive member 334 makes contact with heat conduction member 340 and becomes attached to the heat conduction member 340.

According to the above-described embodiment, since the density d1 of a first shielding member 331 attached to the shield can 320 is lower than the density d2 of a second shielding member 332 attached to the first shielding member 331, the shielding structure 330 may increase the shielding performance of the shielding structure 330 for the electromagnetic waves emitted from the electronic component 301 through the opening 325 and increase the structural stability of the structures on the shielding structure 330 (e.g., the metal plate 350 and/or the display 201 of FIG. 2A).

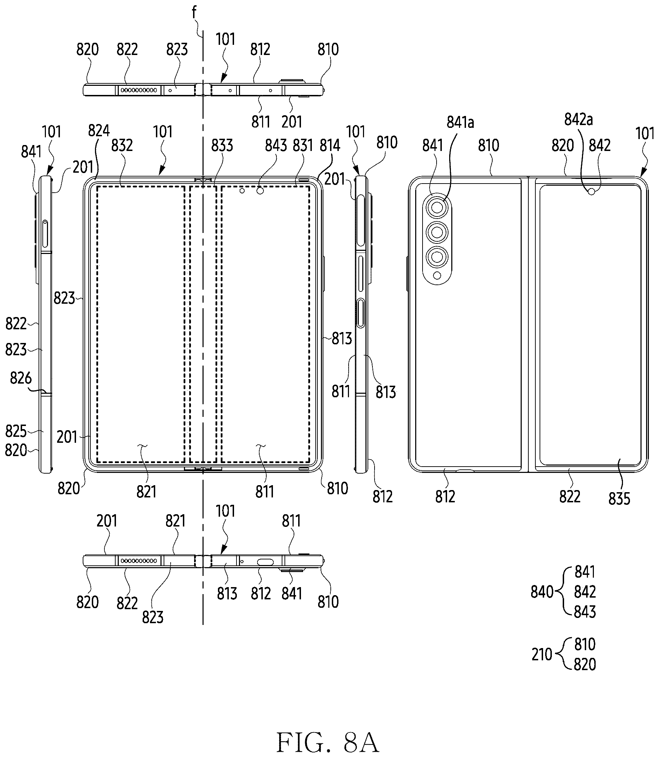

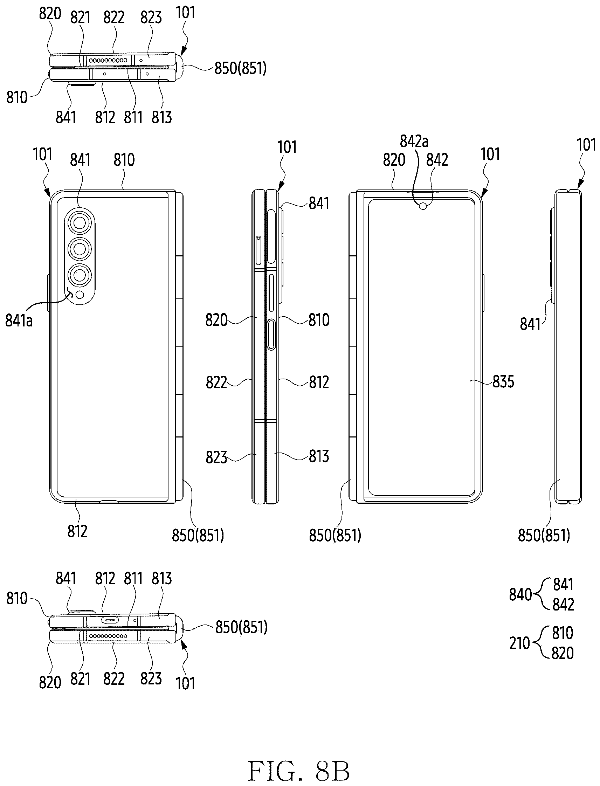

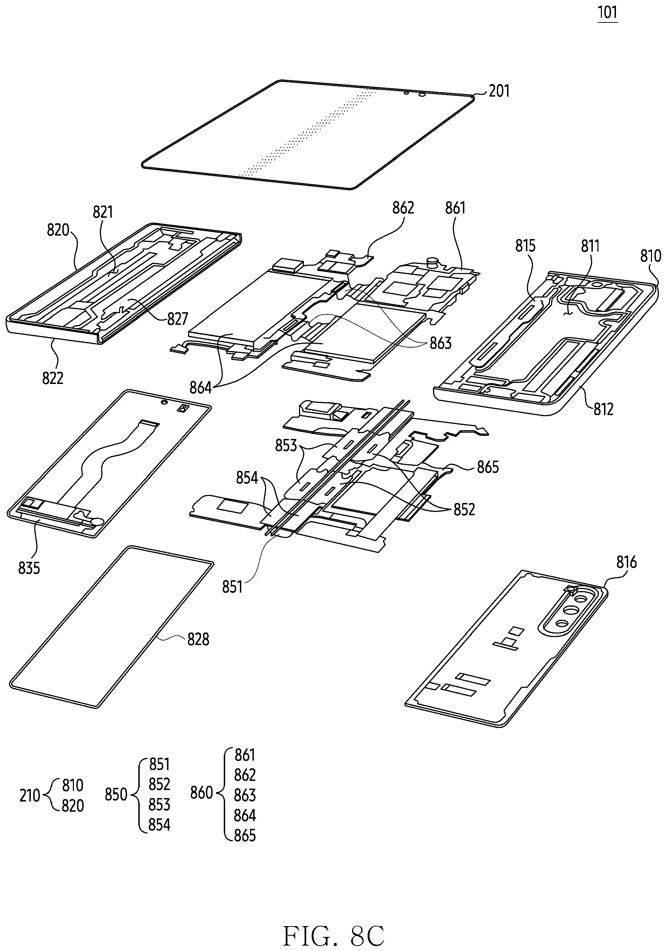

FIG. 8A illustrates an example of an unfolding state of an electronic device according to an embodiment. FIG. 8B illustrates an example of a folding state of an electronic device according to an embodiment. FIG. 8C is an exploded view of an electronic device according to an embodiment.

Referring to FIGS. 8A, 8B, and 8C, the electronic device 101 may include a housing 210 including a first housing 810 and a second housing 820, a display 201, at least one camera 840 (e.g., a camera module 180 of FIG. 1), a hinge structure 850, and/or at least one electronic component 860 (e.g., an electronic component 301 of FIG. 3A).

A first housing 810 and a second housing 820 may form at least a portion of an outer surface of the electronic device 101 that may be gripped by a user. At least a portion of the outer surface of the electronic device 101 defined by the first housing 810 and the second housing 820 may be in contact with a portion of the user's body when the electronic device 101 is used by the user. According to an embodiment, a first housing 810 may include a first front surface 811, a first rear surface 812 facing a first front surface 811 and spaced apart from a first front surface 811, and a first side surface 813 surrounding at least a portion of a first front surface 811 and a first rear surface 812. A first side surface 813 may connect a periphery of a first front surface 811 to a periphery of a first rear surface 812. A first front surface 811, a first rear surface 812, and a first side surface 813 may define an inner space of a first housing 810. According to an embodiment, a first housing 810 may provide the space formed by a first front surface 811, a first rear surface 812, and a first side surface 813 as the space for disposing components of the electronic device 101.

According to an embodiment, a second housing 820 may include a second front surface 821, a second rear surface 822 facing the second front surface 821 and spaced apart from a second front surface 821, and a second side surface 823 surrounding at least a portion of a second front surface 821 and a second rear surface 822. A second side surface 823 may connect a periphery of a second front surface 821 to a periphery of a second rear surface 822. A second front surface 821, a second rear surface 822, and a second side surface 823 may define an inner space of a second housing 820. According to an embodiment, a second housing 820 may provide a space formed by a second front surface 821, a second rear surface 822, and a second side surface 823 surrounding at least a portion of a second front surface 821 and a second rear surface 822 as the space for mounting components of the electronic device 101. According to an embodiment, a second housing 820 may be coupled to a first housing 810 to be rotatable with respect to a first housing 810.

According to an embodiment, each of a first housing 810 and a second housing 820 may include each of a first protection member 814 and a second protection member 824. A first protection member 814 and a second protection member 824 may be disposed on a first front surface 811 and a second front surface 821 along a periphery of the display 201. According to an embodiment, a first protection member 814 and a second protection member 824 may prevent foreign substance (e.g., dust or moisture) from introducing through a gap between the display 201, a first housing 810 and a second housing 820. For example, a first protection member 814 may surround the periphery of a first display region 831 of the display 201, and a second protection member 824 may surround the periphery of a second display region 832 of the display 201. A first protection member 814 may be formed by being attached to a first side surface 813 of a first housing 810, or may be integrally formed with a first side surface 813. A second protection member 824 may be formed by being attached to a second side surface 823 of a second housing 820, or may be integrally formed with a second side surface 823.

According to an embodiment, a first side surface 813 and a second side surface 823 may include a conductive material, a non-conductive material, or a combination thereof. For example, a second side surface 823 may include at least one conductive portion 825 and at least one non-conductive portion 826. At least one conductive portion 825 may include a plurality of conductive portions spaced apart from each other. At least one non-conductive portion 826 may be disposed between a plurality of conductive portions. By at least one non-conductive portion 826 disposed between the plurality of conductive portions, the plurality of conductive portions may be disconnected from each other. According to an embodiment, a plurality of conductive portions and a plurality of non-conductive portions may form an antenna radiator together. The electronic device 101 may be capable of communicating with an external electronic device through the antenna radiator formed by a plurality of conductive portions and a plurality of non-conductive portions.

The display 201 may be configured to display visual information. According to an embodiment, the display 201 may be disposed on a first front surface 811 of a first housing 810 and a second front surface 821 of a second housing 820 across the hinge structure 850. For example, the display 201 may include a first display region 831 disposed on a first front surface 811 of a first housing, a second display region 832 disposed on a second front surface 821 of a second housing, and a third display region 833 disposed between a first display region 831 and a second display region 832. A first display region 831, a second display region 832, and a third display region 833 may form the front surface of the display 201. According to an embodiment, the display 201 may further include a sub-display panel 835 disposed at a second rear surface 822 of a second housing 820. For example, the display 201 may be referred to as a flexible display. According to an embodiment, the display 201 may include a window exposed toward the outside of the electronic device 101. The window may protect the surface of the display 201 and transmit visual information provided by the display 201 to the outside of the electronic device 101, by including a substantially transparent material. For example, the window may include glass (e.g., UTG, ultra-thin glass) and/or polymers (e.g., PI, polyimide), but are not limited thereto. According to an embodiment, the display 201 may be disposed on a metal plate (e.g., a metal plate 350 of FIG. 3A).

According to an embodiment, a second display region 832 may be spaced apart from a first display region 831. A third display region 833 may connect the first display region 831 and the second display region 832 and is foldable based on a folding axis f. A first housing 810 may support the first display region 831. A second housing 820 may support the second display region 832.

At least one camera 840 may be configured to obtain an image based on receiving light from an external subject of the electronic device 101. According to an embodiment, at least one camera 840 may include a third cameras 841, a fourth camera 842, and/or a fifth camera 843. A third cameras 841 may be disposed at a first housing 810. For example, a third cameras 841 may be disposed inside a first housing 810, and at least portion of the third cameras 841 may be visible through a first rear surface 812 of a first housing 810. A third cameras 841 may be supported by a bracket (not illustrated) in a first housing 810. A first housing 810 may include at least one opening 841a overlapping a third cameras 841 when viewing a first rear surface 812 from above. A third cameras 841 may obtain the image based on receiving light from the outside of the electronic device 101 through at least one opening 841a.

According to an embodiment, a fourth camera 842 may be disposed at a second housing 820. For example, a fourth camera 842 may be disposed inside a second housing 820 and may be visible through a sub-display panel 835. A second housing 820 may include at least one opening 842a overlapping a fourth camera 842 when viewing a second rear surface 822 from above. A fourth camera 842 may obtain the image based on receiving light from the outside of the electronic device 101 through at least one opening 842a.

According to an embodiment, a fifth camera 843 may be disposed at a first housing 810. For example, a fifth camera 843 may be disposed inside a first housing 810, and at least portion of the fifth camera 843 may be visible through a first front surface 811 of a first housing 810. For another example, a fifth camera 843 may be disposed inside a first housing 810 and at least portion of the fifth camera 843 may be visible through a first display region 831 of the display 201. A first display region 831 of the display 201 may include at least one opening (not illustrated) overlapping a fifth camera 843 when viewing the display 201 from above. A fifth camera 843 may obtain the image based on receiving light from the outside of the display 201 through at least one opening.

According to an embodiment, a fourth camera 842 and a fifth camera 843 may be disposed under (e.g., in a direction toward the inside of the first housing 810 or the inside of the second housing 820) the display 201. For example, a fourth camera 842 and the fifth camera 843 may be a under display camera (UDC). In case that a fourth camera 842 and a fifth camera 843 is the under-display camera, one region of the display 201 corresponding to a location of each of a fourth camera 842 and a fifth camera 843 may not be an inactive region. For example, in case that a fourth camera 842 and a fifth camera 843 is the under-display camera, one region of the display 201 corresponding to a location of each of a fourth camera 842 and a fifth camera 843 may have a pixel density lower than a pixel density of other region of the display 201. The inactive region of the display 201 may mean one region of the display 201 that does not include the pixel or emit light to the outside of the electronic device 101. For another example, a fourth camera 842 and the fifth camera 843 may be a punch hole camera. In case that a fourth camera 842 and a fifth camera 843 is the punch hole camera, one region of the display 201 corresponding to a location of each of a fourth camera 842 and a fifth camera 843 may be an inactive region. For example, in case that a fourth camera 842 and a fifth camera 843 is the punch hole camera, one region of the display 201 corresponding to a location of each of a fourth camera 842 and a fifth camera 843 may include an opening that does not include the pixel.

According to an embodiment, the hinge structure 850 may connect a first housing 810 and a second housing 820 rotatably. The hinge structure 850 may be disposed between a first housing 810 and a second housing 820 of the electronic device 101 so that the electronic device 101 may be bent, curved, or folded. For example, the hinge structure 850 may be disposed between a portion of a first side surface 813 and a portion of a second side surface 823 facing each other. The hinge structure 850 may change the electronic device 101 into an unfolding state in which the direction that a first front surface 811 of a first housing 810 and a second front surface 821 of a second housing 820 are facing are substantially the same as each other or to a folding state in which a first front surface 811 and a second front surface 821 face each other. When the electronic device 101 is in the folding state, a first housing 810 and a second housing 820 may be superimposed or overlapped by facing each other.

According to an embodiment, the hinge structure 850 may be configured to deform a third display region 833 of the display 201 by rotatably coupling a first housing 810 and a second housing 820.

According to an embodiment, when the electronic device 101 is in the folding state, the direction in which a first front surface 811 faces and the direction in which a second front surface 821 faces may be different from each other. For example, when the electronic device 101 is in the folding state, the direction in which a first front surface 811 faces and the direction in which a second front surface 821 faces may be opposite to each other. For another example, when the electronic device 101 is in the folding state, the direction in which a first front surface 811 faces and the direction in which a second front surface 821 faces may be inclined with respect to each other. In case that the direction in which a first front surface 811 faces is inclined with respect to the direction in which a second front surface 821 faces, a first housing 810 may be inclined with respect to a second housing 820. However, it is not limited thereto. For example, in the folding state of the electronic device 101, a first rear surface 812 of a first housing 810 may face a second rear surface 822 of a second housing 820. In case that a first rear surface 812 and a second rear surface 822 face each other in the folding state of the electronic device 101, the direction in which a first front surface 811 faces and the direction in which a second front surface 821 faces may be opposite to each other. In case that a first rear surface 812 and a second rear surface 822 face each other in the folding state of the electronic device 101, the display 201 may be directly exposed to the outside in the folding state of the electronic device 101.

According to an embodiment, the electronic device 101 may be foldable based on the folding axis f. The folding axis f may mean a virtual line extended through a hinge cover 851 in a direction substantially parallel to the longitudinal direction of the electronic device 101, but is not limited thereto. For example, the folding axis f may be a virtual line extended in the direction substantially perpendicular to the longitudinal direction of the electronic device 101. In case that the folding axis f is extended to the direction substantially perpendicular to the longitudinal direction of the electronic device 101, the hinge structure 850 may connect the first housing 810 and the second housing 820, by being extended to the direction parallel to the folding axis f. A first housing 810 and a second housing 820 may be rotatable by the hinge structure 850 extended to the direction substantially perpendicular to the longitudinal direction of the electronic device 101.

According to an embodiment, the hinge structure 850 may include a hinge cover 851, a first hinge plate 852, a second hinge plate 853, and a hinge module 854. The hinge cover 851 may surround internal components of the hinge structure 850 and form the outer surface of the hinge structure 850. According to an embodiment, when the electronic device 101 is in a folding state, at least a portion of the hinge cover 851 surrounding the hinge structure 850 may be exposed to the outside of the electronic device 101 through a space between a first housing 810 and a second housing 820. According to an embodiment, when the electronic device 101 is in the unfolding state, the hinge cover 851 may not be exposed to the outside of the electronic device 101, by being covered by the first housing 810 and the second housing 820.

According to an embodiment, a first hinge plate 852 and a second hinge plate 853 may rotatably connect a first housing 810 and a second housing 820 by being coupled to a first housing 810 and a second housing 820, respectively. For example, a first hinge plate 852 may be coupled to a first front bracket 815 of a first housing 810 and a second hinge plate 853 may be coupled to a second front bracket 827 of a second housing 820. As a first hinge plate 852 and a second hinge plate 853 are coupled to a first front bracket 815 and a second front bracket 827, respectively, a first housing 810 and a second housing 820 may be rotatable according to a rotation of a first hinge plate 852 and a second hinge plate 853.

The hinge module 854 may rotate a first hinge plate 852 and a second hinge plate 853. For example, the hinge module 854 may rotate a first hinge plate 852 and a second hinge plate 853 based on the folding axis f, by including gears capable of being engaged each other and rotated. According to an embodiment, there may be a plurality of hinge modules 854. For example, a plurality of hinge modules 854 may be disposed to be spaced apart from each other at both end of a first hinge plate 852 and a second hinge plate 853, respectively.

According to an embodiment, a first housing 810 may include a first front bracket 815 and a first rear bracket 816, and a second housing 820 may include a second front bracket 827, and a second rear bracket 828. A first front bracket 815 and a first rear bracket 816 may support components of the electronic device 101. By being coupled to a first rear bracket 816, a first front bracket 815 may define a first housing 810. A first rear bracket 816 may define a portion of the outer surface of a first housing 810. A second front bracket 827 and a second rear bracket 828 may support components of the electronic device 101. By being coupled to a second rear bracket 828, a second front bracket 827 may define the second housing 820. A second rear bracket 828 may define a portion of the outer surface of a second housing 820. For example, the display 201 may be disposed at one surface of a first front bracket 815 and one surface of a second front bracket 827. A first rear bracket 816 may be disposed at the other surface of a first front bracket 815 opposite to one surface of a first front bracket 815. A second rear bracket 828 may be disposed at the other surface of a second front bracket 827 opposite to one surface of a second front bracket 827. The sub-display panel 835 may be disposed between a second front bracket 827 and a second rear bracket 828.

According to an embodiment, a portion of a first front bracket 815 may be surrounded by a first side surface 813, and a portion of a second front bracket 827 may be surrounded by a second side surface 823. For example, a first front bracket 815 may be integrally formed with a first side surface 813, and a second front bracket 827 may be integrally formed with a second side surface 823. For another example, a first front bracket 815 may be formed separately from a first side surface 813, and a second front bracket 827 may be formed separately from a second side surface 823.

At least one electronic component 860 may implement various functions to be provided to a user. According to an embodiment, at least one electronic component 860 may include a first printed circuit board 861 (e.g., a first printed circuit board 250 of FIG. 2B), a second printed circuit board 862 (e.g., a second printed circuit board 252 of FIG. 2B), a flexible printed circuit board 863, a battery 864 (e.g., a battery 189 of FIG. 1), and/or an antenna 865 (e.g., an antenna module 197 of FIG. 1). Each of a first printed circuit board 861 and a second printed circuit board 862 may form an electronical connection of components in the electronic device 101. For example, components (e.g., processor 120 of FIG. 1) for implementing the overall functions of the electronic device 101 may be disposed at a first printed circuit board 861, and electronical components for implementing a portion of functions of a first printed circuit board 861 may be disposed at a second printed circuit board 862. For another example, components for operating the sub-display panel 835 disposed at a second rear surface 822 may be disposed at a second printed circuit board 862.

According to an embodiment, a first printed circuit board 861 may be disposed in a first housing 810. For example, a first printed circuit board 861 may be disposed on one surface of a first front bracket 815. According to an embodiment, a second printed circuit board 862 may be disposed in a second housing 820. For example, a second printed circuit board 862 may be spaced apart from a first printed circuit board 861 and disposed on one surface of a second front bracket 827. The flexible printed circuit board 863 may connect a first printed circuit board 861 and a second printed circuit board 862. For example, the flexible printed circuit board 863 may be extended to a second printed circuit board 862 from a first printed circuit board 861.

The battery 864 is a device for supplying power to at least one component of the electronic device 101, and may include, for example, a non-rechargeable primary battery, a rechargeable secondary battery, or a fuel cell. At least a portion of the battery 864 may be disposed substantially on the same plane as a first printed circuit board 861 or a second printed circuit board 862.

The antenna 865 may be configured to receive power or a signal from the outside of the electronic device 101. According to an embodiment, the antenna 865 may be disposed between a first rear bracket 816 and the battery 864. For example, the antenna 865 may include a near field communication (NFC) antenna, an antenna module, and/or a magnetic secure transmission (MST) antenna. For example, the antenna 865 may perform short-range communication with an external device, or wirelessly transmit and receive power required for charging.

There follows a list of embodiments and examples. The disclosure may comprise any combination of the following embodiments and examples and features thereof, except where such a combination would result in a contradiction.

According to the above-described embodiments, the electronic device (the electronic device 101 of FIG. 1) may include a printed circuit board (e.g., a first printed circuit board 250 and a second printed circuit board 252 of FIG. 2B, a printed circuit board 310 of FIG. 3A), an electronic component coupled on the printed circuit board (e.g., a processor 120 of FIG. 1, an electronic component 301 of FIG. 3A) and a shield can (e.g., a shield can 320 of FIG. 3A) on the printed circuit board surrounding the electronic component and including an opening (e.g., an opening 325 of FIG. 3A) facing the electronic component. The electronic device may include a shielding structure (e.g., shielding structure 330 of FIG. 3A) on the shield can covering the opening and a heat conduction member (e.g., the heat conduction member 340 of FIG. 3A) between the electronic component and the shielding structure attached on the electronic component and contacting with the shielding structure through the opening. The electronic device may include a metal plate (e.g., a metal plate 350 of FIG. 3A) on the shielding structure and at least one heat dissipation member (e.g., at least one heat dissipation member 360 of FIG. 3A) attached to the metal plate and configured to receive at least a portion of heat emitted from the electronic component through the heat conduction member. The shielding structure may include a first shielding member (e.g., the first shielding member 331 of FIG. 3A) attached on the shield can, a first adhesive member (e.g., a first adhesive member 333 of FIG. 3C) interposed between the first shielding member and the shield can to attach the first shielding member to the shield can, a second shielding member (e.g., a second shielding member 332 of FIG. 3A) attached on the first shielding member and a second adhesive member (e.g., a second adhesive member 334 of FIG. 3C) interposed between the first shielding member and the second shielding member to attach the second shielding member to the first shielding member. A density d1 (e.g., d1 of FIG. 3C) of the first shielding member may be smaller than a density (e.g., d2 of FIG. 3C) of the second shielding member. According to the above-described embodiment, by including the shield can, the electronic device may reduce performance degradation of the other electronic components around the electronic component due to electromagnetic waves emitted from the electronic component. The electronic device may reduce performance degradation of the electronic component due to heat emitted from the electronic component, by including the heat conduction member. By including the shielding structure covering the opening, the electronic device may shield electromagnetic waves emitted through the opening from the electronic component. Since the density d1 of the first shielding member is less than the density d2 of the second shielding member, the shielding structure may improve the shielding performance of the shielding structure for the electromagnetic waves emitted from the electronic component through the opening. The electronic device may reduce performance degradation of the electronic device due to heat emitted from the electronic component, by including a metal plate and at least one heat dissipation member. The above-mentioned embodiment may have various effect including the above-mentioned effect.

According to an embodiment, the shielding structure may include a groove indented (e.g., a groove 330a of FIG. 3A) toward the metal plate from the opening to accommodate the heat conduction member penetrating at least a portion of the opening. According to the above-mentioned embodiment, by including the groove, the shielding structure may provide a space for the heat conduction member. The above-mentioned embodiment may have various effect including the above-mentioned effect.

According to an embodiment, the first shielding member may surround at least a portion of the heat conduction member passing through the opening. The second shielding member may be attached on the heat conduction member through the second adhesive member. According to the above-mentioned embodiment, by being attached to the heat conduction member, the shielding structure may receive at least a portion of heat emitted from the electronic component through the heat conduction member. The above-mentioned embodiment may have various effect including the above-mentioned effect.

According to an embodiment, the metal plate may include a heat dissipation portion (e.g., a heat dissipation portion 350a of FIG. 4A) disposed on the electronic component. The at least one heat dissipation member may include a first heat dissipation member (e.g., a first heat dissipation member 361 of FIG. 4D) covering at least a portion of a second surface (e.g., the second surface 352 of FIG. 3A) of the metal plate opposite to a first surface (e.g., a first surface 361 of FIG. 3A) of the metal plate facing the shield can. The electronic device may further include the heat insulation member (e.g., heat insulation member 370 of FIG. 3A) attached to the heat dissipation portion and at least partially surrounded by the first heat dissipation member. According to the above-mentioned embodiment, the electronic device may reduce performance degradation of the electronic device due to the heat emitted from the electronic component by including the heat insulation member and the heat dissipation member. The above-mentioned embodiment may have various effect including the above-mentioned effect.

According to an embodiment, the at least one heat dissipation member may further include the first heat dissipation member and a second heat dissipation member (e.g., a second heat dissipation member 362 of FIG. 4D) disposed on the heat insulation member and covering the heat insulation member. According to the above-mentioned embodiment, by including the second heat dissipation member, the electronic device may reduce performance degradation of the electronic device due to heat emitted from the electronic component. The above-mentioned embodiment may have various effect including the above-mentioned effect.

According to an embodiment, the first shielding member 331 may include a first region (e.g., a first region 331c of FIG. 3C) including an adhesive material by the first adhesive member and a second region (e.g., a second region 331d of FIG. 3C) including an adhesive material by the second adhesive member. At least a portion (e.g., points p1, p2, and p3) of one surface (e.g., a fourth surface 331b of FIG. 3C) of the first shielding member facing the second shielding member may be in contact with the second shielding member. According to the above-mentioned embodiment, since at least a portion of the first shielding member contacts with the second shielding member, the first shielding member may improve the shielding performance of the shielding structure for electromagnetic waves emitted from the electronic component through the opening. The above-mentioned embodiment may have various effect including the above-mentioned effect.

According to an embodiment a thickness (e.g., t1 of FIG. 3C) of the first shielding member may be located in a range of 70µm or more and 80µm or less. A thickness (e.g., t2 of FIG. 3C) of the second shielding member may be located in a range of 10µm or more and 20µm or less. According to the above-mentioned embodiment, the shielding structure may improve the shielding performance of the shielding structure for electromagnetic waves emitted from the electronic component through the opening. The above-mentioned embodiment may have various effect including the above-mentioned effect.

According to an embodiment the heat conduction member may include at least one of rubber, paraffin wax, and oil. According to the above-mentioned embodiment, the heat conduction member may provide structural stability of the structures on the heat conduction member by reducing repulsive force to structures on the heat conduction member pressing the heat conduction member. The above-mentioned embodiment may have various effect including the above-mentioned effect.

According to an embodiment, the metal plate may include a recess (e.g., recess 355 of FIG. 4A) indented toward the heat conduction member from a second surface of the metal plate opposite to a first surface of the metal plate facing the shield can. The at least one heat dissipation member is disposed in the recess so that it may overlap the electronic component when viewing the metal plate from above. According to the above-mentioned embodiment, the metal plate may reduce performance degradation of the electronic device due to heat emitted from the electronic component by including the recess for accommodating the at least one heat dissipation member. The above-mentioned embodiment may have various effect including the above-mentioned effect.

According to an embodiment, the at least one heat dissipation member may cover at least a portion of a first surface of the metal plate facing the shield can and include a third heat dissipation member (e.g., a third heat dissipation member 363 of FIG. 5A) attached to the shielding structure. According to the above-mentioned embodiment, by including the third heat dissipation member, the electronic device may reduce performance degradation of the electronic device due to heat emitted from the electronic component. The above-mentioned embodiment may have various effect including the above-mentioned effect.

According to an embodiment, the electronic device may further include the heat insulation member at least partially surrounded by the third heat dissipation member. The metal plate may include a heat dissipation portion disposed on the electronic component and to which the heat insulation member is attached. The at least one heat dissipation member may further include the third heat dissipation member and a fourth heat dissipation member (e.g., a fourth heat dissipation member 364 of FIG. 5B) disposed on the heat dissipation member and covering the heat insulation member. According to the above-mentioned embodiment, by including the fourth heat dissipation member and the heat dissipation member, the electronic device may reduce performance degradation of the electronic device due to heat emitted from the electronic component. The above-mentioned embodiment may have various effect including the above-mentioned effect.

According to an embodiment, the at least one heat dissipation member may include at least one of vapor chamber, heat pipe, graphite, and graphene. According to the above-mentioned embodiment, the at least one heat dissipation member may reduce performance degradation of the electronic device due to heat emitted from the electronic component. The above-mentioned embodiment may have various effect including the above-mentioned effect.

According to an embodiment, a thickness (e.g., t3 of FIG. 3C) of the first adhesive member and a thickness (e.g., t4 and t5 of FIG. 3C) of the second adhesive member may be located in a range of 1µm or more and 15µm or less, respectively. According to the above-mentioned embodiment, the shielding structure may improve the shielding performance of the shielding structure for electromagnetic waves emitted from the electronic component through the opening. The above-mentioned embodiment may have various effect including the above-mentioned effect.

According to an embodiment, the shielding structure may further include a protection member (e.g., protection member 335 of FIG. 3C) disposed on the second shielding member. According to the above-mentioned embodiment, the shielding structure may reduce performance degradation of the shielding structure due to an external impact by including the protection member. The above-mentioned embodiment may have various effect including the above-mentioned effect.

The electronic device according to an embodiment may include a display (e.g., the display 201 of FIG. 2A) on the metal plate including a first display region (e.g., a first display region 831 of FIG. 8A), a second display region (e.g., a second display region 832 of FIG. 8A) spaced apart from the first display region, and a third display region (e.g., a third display region 833 of FIG. 8A) which connects the first display region and the second display region and is foldable based on a folding axis. The electronic device may further include a first housing (e.g., a first housing 810 of FIG. 8A) supporting the first display region, a second housing (e.g., a second housing 820 of FIG. 8A) supporting the second display region and a hinge structure (e.g., a hinge structure 850 of FIG. 8B) configured to deform the third display region by rotatably coupling the first housing and the second housing. According to the above-mentioned embodiment, the electronic device may provide a variety of user experience to a user by including the hinge structure for rotatably coupling the first housing and the second housing. The above-mentioned embodiment may have various effect including the above-mentioned effect.

According to an embodiment, an electronic device may include a printed circuit board (PCB), an electronic component coupled on the PCB, and a shield can on the PCB surrounding the electronic component and including an opening facing the electronic component. The electronic device may include a shielding structure on the shield can covering the opening and a heat conduction member between the electronic component and the shielding structure attached on the electronic component and contacting the shielding structure through the opening. The electronic device may include a metal plate on the shielding structure and at least one heat dissipation member attached to the metal plate and configured to receive at least a portion of heat emitted from the electronic component through the heat conduction member. The shielding structure may include a first shielding member attached on the shield can, a first adhesive member interposed between the first shielding member and the shield can to attach the first shielding member to the shield can, a second shielding member attached on the first shielding member, a second adhesive member interposed between the first shielding member and the second shielding member to attach the second shielding member to the first shielding member, a protection member disposed on the second shielding member and a groove indented toward the metal plate from the opening to accommodate the heat conduction member penetrating the opening. A density of the first shielding member may be smaller than a density of the second shielding member. According to the above-described embodiment, by including the shield can, the electronic device may reduce performance degradation of the other electronic components around the electronic component due to electromagnetic waves emitted from the electronic component. The electronic device may reduce performance degradation of the electronic component due to heat emitted from the electronic component, by including the heat conduction member. By including the shielding structure covering the opening, the electronic device may shield electromagnetic waves emitted through the opening from the electronic component. Since the density d1 of the first shielding member is less than the density d2 of the second shielding member, the shielding structure may improve the shielding performance of the shielding structure for the electromagnetic waves emitted from the electronic component through the opening. The electronic device may reduce performance degradation of the electronic device due to heat emitted from the electronic component, by including a metal plate and at least one heat dissipation member. The above-mentioned embodiment may have various effect including the above-mentioned effect.

According to an embodiment, the first shielding member may include a first region including an adhesive material from the first adhesive member and a second region including an adhesive material from the second adhesive member. At least a portion of one surface of the first shielding member facing the second shielding member may be in contact with the second shielding member. According to the above-mentioned embodiment, since at least a portion of the first shielding member contacts with the second shielding member, the first shielding member may improve the shielding performance of the shielding structure for electromagnetic waves emitted from the electronic component through the opening. The above-mentioned embodiment may have various effect including the above-mentioned effect.

According to an embodiment the heat conduction member may include at least one of rubber, paraffin wax, and oil. According to the above-mentioned embodiment, the heat conduction member may provide structural stability of the structures on the heat conduction member by reducing repulsive force to structures on the heat conduction member pressing the heat conduction member. The above-mentioned embodiment may have various effect including the above-mentioned effect.

According to an embodiment, the metal plate may include a heat dissipation portion disposed on the electronic component. The at least one heat dissipation member may include a first heat dissipation member covering at least a portion of a second surface of the metal plate opposite to a first surface of the metal plate facing the shield can. The electronic device may further include a heat insulation member attached to the heat dissipation portion and at least partially surrounded by the first heat dissipation member. According to the above-mentioned embodiment, the electronic device may reduce performance degradation of the electronic device due to the heat emitted from the electronic component by including the heat insulation member and the first heat dissipation member. The above-mentioned embodiment may have various effect including the above-mentioned effect.

According to an embodiment, the at least one heat dissipation member may further include a second heat dissipation member disposed on the first heat dissipation member and the heat insulation member, and covering the heat insulation member. According to the above-mentioned embodiment, by including the second heat dissipation member, the electronic device may reduce performance degradation of the electronic device due to heat emitted from the electronic component. The above-mentioned embodiment may have various effect including the above-mentioned effect.

In a first example, there is provided an electronic device comprising: a printed circuit board (PCB); an electronic component disposed on an upper surface of the PCB; a shield can disposed on the PCB and configured to surround the electronic component, wherein the shield can includes an opening facing the electronic component; a shielding structure disposed on the shield can and configured to cover the opening; a heat conduction member disposed between the electronic component and the shielding structure, wherein the heat conduction member is attached to the electronic component and is configured to contact the shielding structure through the opening; and a heat dissipation structure disposed on the shielding structure, wherein the heat dissipation structure comprises a metal plate and at least one heat dissipation member attached to the metal plate, wherein the at least one heat dissipation member is configured to receive at least a portion of heat emitted from the electronic component through the heat conduction member; and wherein the shielding structure includes: a first shielding member attached on the shield can; a first adhesive member interposed between the first shielding member and the shield can to attach the first shielding member to the shield can; a second shielding member attached on the first shielding member; and a second adhesive member interposed between the first shielding member and the second shielding member to attach the second shielding member to the first shielding member; and wherein a density of the first shielding member is smaller than a density of the second shielding member.

In a second example, there is provided the electronic device of the first example, wherein the shielding structure further includes a groove indented toward the metal plate from the opening to accommodate the heat conduction member penetrating through at least a portion of the opening.

In a third example, there is provided the electronic device of the first or second example, wherein the first shielding member surrounds at least a portion of the heat conduction member passing through the opening, and wherein the second shielding member is attached on the heat conduction member by the second adhesive member.

In a fourth example, there is provided the electronic device of any one of the first to third examples, wherein the metal plate includes a heat dissipation portion configured to at least partially overlap the electronic component in a first direction perpendicular to the upper surface of the PCB, and wherein the at least one heat dissipation member includes a first heat dissipation member covering at least a portion of a second surface of the metal plate opposite to a first surface of the metal pate facing the shield can, and wherein the electronic device further comprises a heat insulation member at least partially overlapping the heat dissipation portion in the first direction.

In a fifth example, there is provided the electronic device of the fourth example, wherein the heat insulation member is at least partially surrounded by the first heat dissipation member, and wherein the at least one heat dissipation member further includes a second heat dissipation member disposed on the first heat dissipation member and the heat insulation member and covering the heat insulation member.

In a sixth example, there is provided the electronic device of any one of the first to fifth examples, wherein the first shielding member includes: a first region including adhesive material from the first adhesive member; and a second region including adhesive material from the second adhesive member, and wherein at least a portion of one surface of the first shielding member facing the second shielding member is in contact with the second shielding member.

In a seventh example, there is provided the electronic device of any one of the first to sixth examples, wherein a thickness of the first shielding member is located in a range of 70µm or more and 80µm or less, and wherein a thickness of the second shielding member is located in a range of 10µm or more and 20µm or less.

In an eighth example, there is provided the electronic device of any one of the first to seventh example, wherein the heat conduction member includes at least one of rubber, paraffin wax, and oil.

In a ninth example, there is provided the electronic device of any one of the first to third or sixth to eighth examples, wherein the metal plate includes a recess or a through hole, wherein the recess or the through hole is configured to at least partially overlap the electronic component in a first direction perpendicular to the upper surface of the PCB, wherein the at least one heat dissipation member is disposed in the recess or the through hole, and wherein the recess is formed in a first surface of the metal plate facing the shield can, or the recess is formed in a second surface of the metal plate opposite to the first surface, or wherein the through hole extends from the first surface of the metal plate to the second surface of the metal plate.

In a tenth example, there is provided the electronic device of any one of the first to eighth examples, wherein the at least one heat dissipation member includes a third heat dissipation member covering at least a portion of a first surface of the metal plate facing the shield can.

In an eleventh example, there is provided the electronic device of the tenth example, further comprising: a heat insulation member at least partially surrounded by the third heat dissipation member, wherein the metal plate includes a heat dissipation portion configured to at least partially overlap the electronic component in a first direction perpendicular to the upper surface of the PCB and to which the heat insulation member is attached, and wherein the at least one heat dissipation member further includes a fourth heat dissipation member, disposed on the third heat dissipation member.

In a twelfth example, there is provided the electronic device of any one of the first to eleventh examples, wherein the at least one heat dissipation member includes at least one of vapor chamber, heat pipe, graphite, and graphene.

In a thirteenth example, there is provided the electronic device of any one of the first to twelfth examples, wherein a thickness of the first adhesive member and a thickness of the second adhesive member are each located in a range of 1µm or more and 15µm or less.

In a fourteenth example, there is provided the electronic device of any one of the first to thirteenth examples, wherein the shielding structure further includes a protection member disposed on the second shielding member.

In a fifteenth example, there is provided the electronic device of any one of the first to fourteenth examples, further comprising: a display on the metal plate, the display including a first display region, a second display region spaced apart from the first display region, and a third display region which connects the first display region and the second display region and is foldable based on a folding axis; a first housing supporting the first display region; a second housing supporting the second display region; and a hinge structure configured to deform the third display region by rotatably coupling the first housing and the second housing.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device(101) comprising:
a printed circuit board (PCB)(310);
an electronic component(301) disposed on the PCB(310);
a shield can(320) disposed on the PCB(310) and configured to surround the electronic component(301), wherein the shield can(320) includes an opening(325) facing the electronic component(301);
a shielding structure(330) disposed on the shield can(320) and configured to cover the opening(325);
a heat conduction member(340) disposed between the electronic component(301) and the shielding structure(330), wherein the heat conduction member(340) is attached to the electronic component(301) and is configured to contact the shielding structure(330) through the opening(325); and
a heat dissipation structure disposed on the shielding structure(330),
wherein the heat dissipation structure comprises a metal plate(350) and at least one heat dissipation member(360) attached to the metal plate(350), wherein the at least one heat dissipation member(360) is configured to receive at least a portion of heat emitted from the electronic component(301) through the heat conduction member(340); and
wherein the shielding structure(330) includes:
a first shielding member(331) attached on the shield can(320);
a first adhesive member(333) interposed between the first shielding member(331) and the shield can(320) to attach the first shielding member(331) to the shield can(320);
a second shielding member(332) attached on the first shielding member(331); and
a second adhesive member(334) interposed between the first shielding member(331) and the second shielding member(332) to attach the second shielding member(332) to the first shielding member(331); and
wherein a density(d1) of the first shielding member(331) is smaller than a density(d2) of the second shielding member(332).

2. The electronic device(101) of claim 1,
wherein the shielding structure(330) further includes a groove(330a) indented toward the metal plate(350) from the opening(325) to accommodate the heat conduction member(340) penetrating through at least a portion of the opening.

3. The electronic device(101) of claim 1 or 2,
wherein the first shielding member(331) surrounds at least a portion of the heat conduction member(340) passing through the opening(325), and
wherein the second shielding member(332) is attached on the heat conduction member(340) by the second adhesive member(334).

4. The electronic device(101) of any one of claims 1 to 3,
wherein the metal plate(350) includes a heat dissipation portion(350a) configured to at least partially overlap the electronic component(301) in a first direction perpendicular to an upper surface of the PCB(310) on which the electronic component(301) is disposed, and
wherein the at least one heat dissipation member(360) includes a first heat dissipation member(361) covering at least a portion of a second surface(352) of the metal plate(350) opposite to a first surface(351) of the metal plate(350) facing the shield can(320), and
wherein the electronic device(101) further comprises a heat insulation member(370) at least partially overlapping the heat dissipation portion(350a) in the first direction.

5. The electronic device(101) of claim 4,
wherein the heat insulation member(370) is at least partially surrounded by the first heat dissipation member(361), and
wherein the at least one heat dissipation member(360) further includes a second heat dissipation member(362) disposed on the first heat dissipation member(361) and the heat insulation member(370) and covering the heat insulation member(370).

6. The electronic device(101) of any one of claims 1 to 5,
wherein the first shielding member(331) includes:
a first region(331c) including adhesive material from the first adhesive member(333); and
a second region(331d) including adhesive material from the second adhesive member(334); and
wherein at least a portion of one surface(331b) of the first shielding member(331) facing the second shielding member(332) is in contact with the second shielding member(332).

7. The electronic device(101) of any one of claims 1 to 6,
Wherein a thickness(t1) of the first shielding member(331) is located in a range of 70µm or more and 80µm or less, and
wherein a thickness(t2) of the second shielding member(332) is located in a range of 10µm or more and 20µm or less.

8. The electronic device(101) of any one of claims 1 to 7,
Wherein the heat conduction member(340) includes at least one of rubber, paraffin wax, and oil.

9. The electronic device(101) of any one of claims 1 to 3, or 6 to 8,
wherein the metal plate(350) includes a recess or a through hole, wherein the recess or the through hole is configured to at least partially overlap the electronic component(301) in a first direction perpendicular to an upper surface of the PCB(310) on which the electronic component(301) is disposed,
wherein the at least one heat dissipation member(360) is disposed in the recess or the through hole, and
wherein the recess is formed in a first surface(351) of the metal plate(350) facing the shield can(320), or the recess is formed in a second surface(352) of the metal plate(350) opposite to the first surface(351),
wherein the through hole extends from the first surface(351) of the metal plate(350) to the second surface(352) of the metal plate(350).

10. The electronic device(101) of any one of claims 1 to 8,
wherein the at least one heat dissipation member(360) includes a third heat dissipation member(363) covering at least a portion of a first surface(351) of the metal plate(350) facing the shield can(320).

11. The electronic device(101) of claim 10 further comprising:
a heat insulation member(370) at least partially surrounded by the third heat dissipation member(363), and
wherein, the metal plate(350) includes a heat dissipation portion(350a) disposed on the electronic component(301) and to which the heat insulation member(370) is attached, and
wherein the at least one heat dissipation member(360) further includes a fourth heat dissipation member(364), disposed on the third heat dissipation member(363).

12. The electronic device(101) of any one of claims 1 to 11,
wherein the at least one heat dissipation member(360) includes at least one of vapor chamber, heat pipe, graphite, and graphene.

13. The electronic device(101) of any one of claims 1 to 12,
Wherein a thickness(t3) of the first adhesive member(333) and a thickness(t4) of the second adhesive member(334) are each located in a range of 1µm or more and 15µm or less.

14. The electronic device(101) of any one of claims 1 to 13,
wherein the shielding structure(330) further includes a protection member(335) disposed on the second shielding member(332).

15. The electronic device(101) of any one of claims 1 to 14 further comprising:
a display(201) on the metal plate(350), the display(201) including a first display region(831), a second display region(832) spaced apart from the first display region(831), and a third display region(833) which connects the first display region(831) and the second display region(832) and is foldable based on a folding axis(f);
a first housing(810) supporting the first display region(831);
a second housing(820) supporting the second display region(832); and
a hinge structure(850) configured to deform the third display region(833) by rotatably coupling the first housing(810) and the second housing(820).
